# EUROPÄISCHE PATENTSCHRIFT

(11) **EP 2 856 523 B1**
(45) Veröffentlichungstag und Bekanntmachung des Hinweises auf die Patenterteilung: **02.09.2020**
(21) Anmeldenummer: 13723487.8
(22) Anmeldetag: 15.05.2013
(51) Int. Cl.: H01L 33/62, H01L 25/075, H01L 33/54

(54) **VERFAHREN ZUR HERSTELLUNG EINES OPTOELEKTRONISCHEN MODULS**
METHOD FOR PRODUCING AN OPTOELECTRONIC MODULE
PROCÉDÉ DE FABRICATION D'UN MODULE OPTOÉLECTRONIQUE

(30) Priorität: 01.06.2012 DE 102012209325
(43) Veröffentlichungstag der Anmeldung: 08.04.2015
(73) Patentinhaber: OSRAM Opto Semiconductors GmbH, 93055 Regensburg (DE)
(72) Erfinder: ILLEK, Stefan, 93093 Donaustauf (DE)
(74) Vertreter: Epping - Hermann - Fischer
(86) Internationale Anmeldenummer: PCT/EP2013/060053
(87) Internationale Veröffentlichungsnummer: WO 2013/178469

(56) Entgegenhaltungen:
- EP-A2- 2 423 717
- DE-A1- 10 229 067
- DE-A1-102008 057 350
- DE-A1-102009 022 966
- DE-A1-102010 028 407
- DE-A1-102010 031 732
- JP-A- S5 752 072
- US-A1- 2011 024 772
- US-A1- 2011 193 105

## Beschreibung

Die vorliegende Erfindung betrifft ein optoelektronisches Modul und ein Verfahren zur Herstellung eines optoelektronischen Moduls.

Optoelektronische Module können eine Mehrzahl an Halbleiterchips aufweisen, die auf einem Träger angeordnet sind. Ein mögliches Ziel kann es sein, eine Flächenleuchte mit einer homogenen Leuchtdichte zur Verfügung zu stellen. Die hierfür notwendige Anordnung vieler Halbleiterchips kann jedoch unter anderem aus Gründen der Verschaltbarkeit und der Kontaktierbarkeit nachteilig sein.

Die Druckschrift DE 10 2010 031 732 A1 beschreibt ein optoelektronisches Bauelement mit einem Halbleiterchip zur Emission elektromagnetischer Strahlung auf einem Trägerelement. Zur elektrischen Kontaktierung des Halbleiterchips sind auf dem Trägerelement eine erste elektrische Anschlussfläche und eine zweite elektrische Anschlussfläche angeordnet. Eine Kontaktstruktur verbindet die erste elektrische Anschlussfläche des Trägerelements mit einem oberen Kontaktbereich des Halbleiterchips. Der Halbleiterchip ist dabei von einer transparenten Vergussmasse umgeben, wobei die Oberfläche der Kontaktstruktur bündig mit einer Hauptfläche abschließt, sodass eine planare Ebene des Bauelements erzeugt wird.

Die Druckschrift JPS_5752072 _A beschreibt ein Passivmatrixdisplay mit einer Vielzahl von Leuchtdiodenchips, die getrennt voneinander betreibbar sind.

Die Druckschrift US 2011/193105 A1 beschreibt ein Verfahren zur Herstellung einer Folie.

Die Druckschrift US 2011/024772 A1 beschreibt ein Verfahren zum elektrischen Kontaktieren einer Anordnung mehrerer Halbleiterstrukturen.

Eine Aufgabe der Erfindung ist es, ein Verfahren zur Herstellung eines optoelektronischen Moduls anzugeben, das besonders kostengünstig ist.

Die Aufgabe wir durch das Verfahren gemäß Anspruch 1 gelöst.

Es wird insbesondere ein optoelektronisches Modul mit mindestens einem Halbleiterchip zur Emission elektromagnetischer Strahlung angegeben. Das oelektronische Modul ist kein Teil der beanspruchten Erfindung. Z Der Halbleiterchip weist eine Schicht einer ersten Leitfähigkeit, insbesondere einer p-Leitfähigkeit, eine Schicht einer zweiten Leitfähigkeit, insbesondere einer n-Leitfähigkeit, eine Abstrahlfläche und eine der Abstrahlfläche gegenüberliegende Kontaktfläche auf. Auf der Abstrahlfläche ist ein Kontakt aufgebracht. Ein Rahmen aus Vergussmasse umschließt den mindestens einen Halbleiterchip seitlich zumindest bereichsweise derart, dass die Abstrahlfläche und die Kontaktfläche im Wesentlichen frei von Vergussmasse sind. Eine erste Kontaktstruktur ist zumindest bereichsweise auf dem Rahmen und zumindest bereichsweise auf der Kontaktfläche angeordnet und dient zur elektrischen Kontaktierung der Schicht einer ersten Leitfähigkeit. Eine zweite Kontaktstruktur ist zumindest bereichsweise auf dem Rahmen und zumindest bereichsweise auf dem Kontakt der Abstrahlfläche angeordnet und dient zur elektrischen Kontaktierung der Schicht einer zweiten Leitfähigkeit. Besonders vorteilhaft ist hierbei die vollständige Trennung von optischen und elektrischen Funktionen. Das spätere Aufbringen eines optischen Elements, insbesondere eines Mischelements zur räumlichen Durchmischung elektromagnetischer Strahlung, hat eine rein optische Funktion. Die erste Kontaktstruktur, die zweite Kontaktstruktur und der Kontakt auf der Abstrahlfläche haben eine rein elektrische Funktion.

Das Einbetten des mindestens einen Halbleiterchips in einem Rahmen aus Vergussmasse und das Führen der Kontaktstrukturen über den Rahmen sind vorteilhaft, da es die Kontaktierung des mindestens einen Halbleiterchips vereinfacht und verbilligt. Insbesondere eignet sich das Modul für eine bonddrahtfreie Kontaktierung.

Weiterhin ist es vorteilhaft, dass zunächst sämtliche elektrische Anschlüsse realisiert werden, bevor optische Elemente, wie beispielsweise Mischelemente, aufgesetzt werden. Dies ermöglicht es, dass die Kontaktstrukturen getestet und bei Bedarf nachgearbeitet werden können, bevor das optische Element aufgesetzt wird.

In einer bevorzugten Ausführungsform weisen die Halbleiterchips eine Kantenlänge von etwa 50 µm bis etwa 200 µm auf. Eine Vielzahl solch kleiner Halbleiterchips ist vorteilhaft für die Erzeugung von Flächenlichtquellen mit einer homogenen Leuchtdichte.

Durch den Einsatz des Rahmens aus Vergussmasse kann der minimale Abstand der Halbleiterchips zueinander Werte von etwa 20 µm erreichen.

Die Dicke des Rahmens entspricht im Wesentlichen der Dicke des Halbleiterchips. Dies ist vorteilhaft, da der Halbleiterchip an seinen Seitenflächen vollständig von Vergussmasse umgeben ist und nicht über den Rahmen hinausragt. Die minimal mögliche Dicke des Rahmens liegt bei etwa 100 µm. Die Dicke des Halbleiterchips ergibt sich aus der Dicke der Epitaxieschichten und der Dicke des, insbesondere elektrisch leitfähigen, Substrats, auf dem die Epitaxieschichten aufgebracht sind. Als ein solches Substrat kann Germanium dienen. Die Dicke des Rahmens schwankt dabei zum Beispiel um höchstens +/- 10 %, insbesondere um höchstens +/- 5 % um die maximale Dicke des Halbleiterchips.

In einer bevorzugten Ausführungsform weist die Vergussmasse wenigstens eines der folgenden Materialien auf:
- Silikon
- Epoxydharz
- Hybridmaterialien.

Silikon als Vergussmasse ist besonders vorteilhaft, da es temperaturstabil ist. Zudem ist Silikon strahlungsstabil gegenüber elektromagnetischer Strahlung im gesamten sichtbaren Spektralbereich. Epoxydharz als Vergussmasse ist besonders vorteilhaft, da es billig ist. Hybridmaterialien sind besonders vorteilhaft, da sie die Vorteile von Silikon und Epoxydharz kombinieren.

In einer bevorzugten Ausführungsform sind in die Vergussmasse Partikel dispergiert, die wenigstens eines der folgenden Materialien aufweisen:
- Titandioxid (TiO₂),
- Aluminiumoxid (Al₂O₃),
- Zirkoniumoxid (ZrO),
- Bariumdifluorid (BaF₂).

Diese Partikel wirken als Streupartikel mit einer diffusen Reflektivität (Einfallswinkel ist meist ungleich zu Ausfallswinkel). Die Streupartikel können vorteilhafter Weise eine Korngröße von etwa 500 nm bis etwa 3 µm aufweisen. Damit liegt der Durchmesser der Streupartikel im Bereich der Wellenlänge des Lichtes, das gestreut werden soll.

Alternativ oder zusätzlich zu den Streupartikeln können in die Vergussmasse spekular reflektierende Partikel (Einfallswinkel ist meist gleich Ausfallswinkel) eingebracht sein, die wenigstens eines der folgenden Materialien aufweisen:
- Silber (Ag),
- Aluminium (Al),
- Quanten-Dots.

Streupartikel und spekular reflektierende Partikel in der Vergussmasse sind vorteilhaft, da diese Partikel zumindest einen Teil des auftreffenden Lichtes zurückwerfen. Die Absorptionsverluste in der Vergussmasse werden dadurch reduziert.

In einer bevorzugten Ausführungsform sind in die Vergussmasse Partikel dispergiert, die Siliziumdioxid (SiO₂) aufweisen. Dies ist vorteilhaft, da die SiO₂-Partikel zu einer Verringerung des thermischen Ausdehnungskoeffizienten der Vergussmasse führen.

In einer bevorzugten Ausführungsform sind in die Vergussmasse Partikel dispergiert, die Ruß aufweisen. Der Einsatz von Rußpartikel ist für Anwendungen vorteilhaft, bei denen Licht, das auf die Vergussmasse auftrifft, absorbiert werden soll.

Die erste und die zweite Kontaktstruktur weisen elektrisch leitfähiges Material auf. Das elektrisch leitfähige Material kann Metalle und metallische Legierungen aufweisen.

In einer bevorzugten Ausführungsform weist der Kontakt auf der Abstrahlfläche eine transparente Kontaktschicht, insbesondere aus Indiumzinnoxid und/oder Zinkoxid, auf. Die transparente Kontaktschicht bedeckt die Abstrahlfläche des Halbleiterchips zumindest bereichsweise, vorzugsweise vollflächig. Das Fehlen von metallischen Kontaktstrukturen auf der Lichtemissionsseite des Halbleiterchips ermöglicht eine plane Oberfläche des Halbleiterchips. Diese plane Oberfläche ist vorteilhaft für die effiziente Einkopplung von elektromagnetischer Strahlung aus dem Halbleiterchip in ein nachgeordnetes optisches Element, wie ein Mischelement. Besonders vorteilhaft ist es, dass die Abschattung durch den Bonddraht entfällt. Zudem geht keine lichtemittierende Fläche durch ein Bondpad auf der Abstrahlfläche des Halbleiterchips verloren.

In einer alternativen bevorzugten Ausführungsform weist der Kontakt auf der Abstrahlfläche ein Kontaktpad auf. Das Kontaktpad bedeckt weniger als 30 %, vorzugsweise weniger als 15 % der Abstrahlfläche. Das Kontaktpad kann ein Metall wie Gold oder Silber oder eine metallische Legierung aufweisen und kann in unmittelbarem Kontakt mit der Abstrahlfläche sein. Der elektrische Kontakt zwischen dem Anteil der zweiten Kontaktstruktur, die auf dem Rahmen verläuft, und dem Kontaktpad auf der Abstrahlfläche wird durch eine elektrisch leitende im Wesentlichen planare Kontaktschicht hergestellt. Die Technologie zur Herstellung solcher planaren Kontaktschichten ist in einem anderen Zusammenhang zum Beispiel in der Druckschrift US2009/0127573 beschrieben. Die planare Schicht kann eine Dicke zwischen 5 µm und 60 µm, vorzugsweise zwischen 15 µm und 25 µm aufweisen. Die Breite der planaren Schicht kann zwischen 5 µm und 200 µm, vorzugsweise zwischen 15 µm und 100 µm, betragen. Der Einsatz der obigen planaren Schicht zur Kontaktierung des Kontaktpads ist vorteilhaft, da die planare Schicht eine hohe Stromtragfähigkeit und eine im Vergleich zu einem herkömmlichen Bonddraht geringe Bauhöhe aufweist. Zudem können vergleichsweise kleine Kontaktpads durch die obige planare Schicht kontaktiert werden. Die Abschattung durch diese vergleichsweise kleinen Kontaktpads ist gegenüber der Abschattung durch die vergleichsweise großen Bondpads beim herkömmlichen Drahtbonden deutlich reduziert. Die Kontaktpads sind um einen Flächenfaktor von 10 bis 100 kleiner als herkömmliche Bondpads.

In einer bevorzugten Ausführungsform ist auf der Seite des Rahmens, die an die Kontaktfläche angrenzt, und auf der Kontaktfläche selbst eine elektrisch isolierende Isolationsschicht, insbesondere aus einem Dielektrikum, aufgebracht. Auf die Isolationsschicht wird eine, insbesondere metallische, Wärmesenke aufgebracht. Die Wärmesenke führt zu einer Wärmespreizung, also einer Verteilung der Wärme über die Fläche. Dies ist besonders vorteilhaft beim Einsatz von Halbleiterchips höherer Leistung. Die gespreizte Wärme kann dann über Konvektion besser an die Umgebungsluft abgegeben werden.

In einer bevorzugten Ausführungsform ist die erste Kontaktstruktur auf der Seite des Rahmens, die an die Kontaktfläche angrenzt, aufgebracht. Die zweite Kontaktstruktur ist auf der Seite des Rahmens, die an die Abstrahlfläche angrenzt, aufgebracht.

In einer bevorzugten Ausführungsform weist das optoelektronische Modul ein Konversionselement auf. Das Konversionselement kann als Wirtsmaterial Silikon oder ein keramisches Material aufweisen. In das Wirtsmaterial können Leuchtstoffpartikel eingebettet sein. Das Konversionselement ist dem Halbleiterchip in Abstrahlrichtung nachgeordnet. Das Konversionselement ist vorteilhaft, um auf effiziente Weise kurzwelliges Primärlicht in längerwelliges Sekundärlicht zu wandeln. Leuchtstoffpartikel können insbesondere blaues Licht in gelbes Licht wandeln. Die Leuchtstoffpartikel können wenigstens eines der folgenden Materialien aufweisen:
- Lanthan dotiertes Yttriumoxid (Y₂O₃-La₂O₃),
- Yttriumaluminiumgranat (Y₃Al₅O₁₂),
- Dysprosiumoxid (Dy₂O₃),
- Aluminiumoxynitrid (Al₂₃O₂₇N₅) oder
- Aluminiumnitrid (AlN).

In einer bevorzugten Ausführungsform weist das optoelektronische Modul ein Mischelement auf. Das Mischelement dient zur räumlichen und spektralen Durchmischung der elektromagnetischen Strahlung des mindestens einen Halbleiterchips. Das Mischelement ist dem mindestens einen Halbleiterchip in Abstrahlrichtung nachgeordnet. Das Mischelement kann wenigstens eines der Matrixmaterialien
- Glas (SiO₂),
- Silikon,
- Polymethylmethacrylat (PMMA),
- Polycarbonat (PC)
aufweisen.

Der Einsatz von Glas oder Silikon ist besonders vorteilhaft, da diese Materialien kostengünstig und einfach in der Verarbeitung sind.

Besonders vorteilhaft ist beim Einsatz des Mischelements die vollständige Trennung von optischen und elektrischen Funktionen. Das Mischelement zur räumlichen Durchmischung elektromagnetischer Strahlung, hat eine rein optische Funktion. Die erste Kontaktstruktur, die zweite Kontaktstruktur und der Kontakt auf der Abstrahlfläche hat eine rein elektrische Funktion.

In vorteilhafter Weise können in das Matrixmaterial des Mischelements Streupartikel eingebettet sein. Die Streupartikel weisen wenigstens eines der folgenden Materialien auf:
- Titandioxid (TiO₂),
- Aluminiumoxid (Al₂O₃),
- Zirkoniumoxid (ZrO),
- Bariumdifluorid (BaF₂).

Der Einsatz von Streupartikel ist besonders vorteilhaft, da durch die Streupartikel, die für die Lichtdurchmischung notwendige Mindestdicke des Mischelements reduziert werden kann.

In einer bevorzugten Ausführungsform ist zwischen dem Rahmen und dem Mischelement zumindest bereichsweise eine strukturierte Spiegelschicht, insbesondere eine metallische Spiegelschicht, oder eine strukturierte Streuschicht, insbesondere aus Silikon, in das Streupartikel dispergiert sind, angeordnet. Eine solche Spiegelschicht oder Streuschicht ist vorteilhaft, da nicht ausgekoppeltes Licht in das Mischelement zurückgeworfen werden kann und in der Folge vom optoelektronischen Modul abgestrahlt werden kann.

Die strukturierte Spiegelschicht beziehungsweise die strukturierte Streuschicht können derart zwischen dem Rahmen und dem Mischelement angeordnet sein, dass der Halbleiterchip des Moduls von der strukturierten Spiegelschicht beziehungsweise der strukturierten Streuschicht an seiner Abstrahlfläche rahmenartig umgeben ist. Im Betrieb erzeugte elektromagnetische Strahlung tritt dann durch eine Ausnehmung in der strukturierten Spiegelschicht beziehungsweise in der strukturierten Streuschicht von der Abstrahlfläche in das Mischelement ein.

Für den Fall, dass das optoelektronische Modul zumindest zwei Halbleiterchips umfasst, sind Bereiche der strukturierten Spiegelschicht beziehungsweise der strukturierten Streuschicht zwischen unmittelbar benachbarten Halbleiterchips des Moduls angeordnet. Die strukturierte Spiegelschicht beziehungsweise die strukturierte Streuschicht dient dann auch zur optischen Entkopplung zwischen benachbarten Halbleiterchips.

In einer bevorzugten Ausführungsform ist zwischen der Abstrahlfläche und dem Mischelement ein transparentes Brechungsindex-Anpassungselement, insbesondere aus Silikon, vorgesehen. Ein solches Anpassungselement auf Silikon-Basis wird auch "Index-Matching-Gel" genannt. Der Brechungsindex des transparenten Brechungsindex-Anpassungselements liegt zwischen dem Brechungsindex des Halbleiterchips und dem Brechungsindex des Mischelements. Dies ist vorteilhaft, da die vom Halbleiterchip emittierte elektromagnetische Strahlung effizienter in das Mischelement eingekoppelt werden kann.

In einer bevorzugten Ausführungsform entspricht der Abstand zwischen benachbarten Halbleiterchips im Wesentlichen der Dicke des Mischelements. "Im Wesentlichen" kann dabei heißen, dass die Dicke des Mischelements um höchstens +/- 10 %, bevorzugt um +/- 5 % um den Abstand zwischen unmittelbar benachbarten Halbleiterchips abweicht. Bevorzugte Werte für die Dicke liegen zwischen 1 mm und 10 mm, vorzugsweise zwischen 3 mm und 6 mm, besonders bevorzugt bei 4 mm. Das Einhalten des obigen Zusammenhangs von Dicke des Mischelements zu Abstand der Halbleiterchips ist vorteilhaft, da dadurch eine ausreichende Mischung der lambertschen Lichtabstrahlung der einzelnen Halbleiterchips erreicht werden kann. Dies ermöglicht eine Flächenleuchte mit einer im Wesentlichen homogen leuchtenden Fläche.

In einer bevorzugten Ausführungsform sind mindestens zwei Halbleiterchips vorgesehen. Im einfachsten Fall sind die Halbleiterchips parallel miteinander verschaltet. In einer weiteren bevorzugten Ausführungsform sind die Halbleiterchips seriell miteinander verschaltet. Die serielle Verschaltung ist besonders vorteilhaft, da diese eine im Wesentlichen homogene Stromverteilung auf die Halbleiterchips ermöglicht. In einer weiteren bevorzugten Ausführungsform können mehrere Stränge von Halbleiterchips parallel bestromt werden, wobei die Halbleiterchips in jedem Strang seriell bestromt werden.

In einer bevorzugten Ausführungsform ist im Rahmen aus Vergussmasse mindestens eine elektrische Durchführung vorgesehen. Die elektrische Durchführung kann ein Metall aufweisen. Die elektrische Durchführung kann durch Ausstanzen oder Laserbearbeitung aus einer Kupferfolie hergestellt werden. Alternativ kann die elektrische Durchführung Silizium aufweisen. Die elektrische Durchführung verbindet die erste Kontaktstruktur eines Halbleiterchips mit der zweiten Kontaktstruktur eines benachbarten Halbleiterchips elektrisch leitend. Die elektrische Durchführung ist für eine serielle Verschaltung der Halbleiterchips zwingend notwendig.

Gemäß zumindest einer Ausführungsform des hier beschriebenen Moduls weist das Mischelement zumindest eine Kavität an seiner dem Halbleiterchip zugewandten Unterseite auf. Die Kavität ist dabei insbesondere derart ausgebildet, das sie das Mischelement nicht vollständig durchdringt. Weist das Modul zwei oder mehr Halbleiterchips auf, so weist das Mischelement zwei oder mehr Kavitäten auf, wobei jedem Halbleiterchip eine Kavität des Mischelements eineindeutig zugeordnet ist. Die Kavitäten sind an der den Abstrahlflächen der Halbleiterchips zugewandten Seite des Mischelements angeordnet. Insbesondere kann jede Kavität ein Konversionselement umfassen, das dem zugeordneten Halbleiterchip in Abstrahlrichtung nachgeordnet ist. Beispielsweise ist das Konversionselement mit einem Matrixmaterial wie Silikon gebildet, in das Partikel eines oder mehrerer Leuchtstoffe eingebracht sind. Jede Kavität kann vollständig mit einem Konversionselement befüllt sein, wobei unterschiedliche Kavitäten unterschiedliche Konversionselemente umfassen können. Damit ist es dann zum Beispiel möglich, dass von unterschiedlichen Konversionselementen Licht unterschiedlicher Farbe oder weißes Licht unterschiedlicher Farbtemperatur abgestrahlt wird.

Es wird des Weiteren ein erfindungsgemäßes Verfahren zum Herstellen eines optoelektronischen Moduls angegeben. Mit dem Verfahren kann insbesondere ein hier beschriebenes Modul hergestellt werden. Das heißt, sämtliche für das Modul beschriebenen Merkmale sind auch für das Verfahren offenbart und umgekehrt. Ein hier beschriebenes Verfahren weist dabei die folgenden Schritte auf:
- Aufbringen mindestens eines Halbleiterchips zur Emission elektromagnetischer Strahlung auf eine Klebefolie, wobei der Halbleiterchip eine Schicht einer ersten Leitfähigkeit, eine Schicht einer zweiten Leitfähigkeit, eine Abstrahlfläche mit einem Kontakt und eine der Abstrahlfläche gegenüberliegende Kontaktfläche aufweist, wobei die Abstrahlfläche zur Klebefolie weist;
- Aufbringen eines Rahmens aus Vergussmasse, zum Beispiel durch Vergießen, auf die freiliegenden Bereiche der Klebefolie, derart, dass der Halbleiterchip seitlich zumindest bereichsweise von Vergussmasse umschlossen wird;
- Aufbringen einer ersten Kontaktstruktur auf den Rahmen und auf die Kontaktfläche zur elektrischen Kontaktierung der Schicht einer ersten Leitfähigkeit, zum Beispiel einer p-Leitfähigkeit;
- Entfernen der Klebefolie;
- Aufbringen einer zweiten Kontaktstruktur auf den Rahmen und auf den Kontakt der Abstrahlfläche, zur elektrischen Kontaktierung der Schicht einer zweiten Leitfähigkeit, zum Beispiel einer n-Leitfähigkeit.

Der Einsatz einer Klebefolie zum Befestigen des mindestens einen Halbleiterchips ist vorteilhaft, da es ausreicht, die Halbleiterchips auf der Klebefolie abzulegen, ohne dass besonders enge Platzierungstoleranzen eingehalten werden müssen. Die Haftkraft der Klebefolie ist dabei so zu wählen, dass die Halbleiterchips für die folgenden Verfahrensschritte ausreichend fest haften. Jedoch muss die Haftkraft derart begrenzt sein, dass die Klebefolie nach dem Aufbringen der ersten Kontaktstruktur von den Halbleiterchips und von dem Rahmen aus Vergussmasse abgelöst werden kann, ohne Rückstände zu hinterlassen oder den mindestens einen Halbleiterchip zu beschädigen. Das Vergießen des mindestens einen Halbleiterchips in einem Rahmen aus Vergussmasse und das Führen der Kontaktstrukturen über den Rahmen sind vorteilhaft, da es die Kontaktierung des Halbleiterchips vereinfacht und verbilligt. Weiterhin ist es vorteilhaft, dass erfindungsgemäß zunächst sämtliche elektrische Anschlüsse realisiert werden, bevor optische Komponenten, wie beispielsweise Mischelemente, aufgesetzt werden. Dies ermöglicht es, dass die Kontaktstrukturen getestet und bei Bedarf nachgearbeitet werden können, bevor die optische Komponente aufgesetzt wird.

Das Aufbringen der ersten und der zweiten Kontaktstruktur kann durch ein flächiges Aufbringen einer Metallisierung erfolgen. Ein möglicher Vorteil flächiger Leitungsstrukturen ist es, dass diese im Vergleich zu Bonddrähten beim klassischen Drahtbonden eine höhere Stromtragfähigkeit aufweisen können. Auch kann durch flächige Leitungsstrukturen die Bauhöhe des optoelektronischen Bauelements gegenüber dem klassischen Drahtbonden reduziert werden.

Das flächige Aufbringen der Metallisierung auf den Rahmen, auf den Kontakt auf der Abstrahlfläche und auf die Kontaktfläche kann unmittelbar strukturiert oder durch Einsatz der sogenannten Fototechnik erfolgen.

Für das unmittelbar strukturierte Aufbringen der Metallisierung können alternativ folgende Verfahren verwendet werden:
- Siebdrucken, bei dem durch Verwendung von Schablonen oder Abdeckmasken eine flächige Metallisierung auf den Rahmen und auf die Halbleiterchips aufgebracht wird. Hierbei wird eine elektrisch leitfähige Paste aufgerakelt. In einem Prozessschritt können Metallisierungsdicken von etwa 30 µm erreicht werden. Vorzugsweise kann für eine erhöhte Stromleitfähigkeit und eine erhöhte Stabilität der metallisierten Struktur der Prozessschritt mehrfach wiederholt werden.

- Dispensen, bei dem Metallpartikel und ein organisches Medium zu einer Paste vermengt sind und diese Paste mittels einer Kanüle und einer Spritze durch Druckluftimpulse auf den Rahmen aufgebracht wird. Anschließend wird die Paste getrocknet und getempert. Besonders vorteilhaft ist es dabei, dass über die Parameter Druck und Zeit eine beliebige Form der Metallisierung erreicht werden kann. Durch Dispensen wird eine sehr gut haftende Metallisierungsschicht erzeugt. Es können Dicken der Metallisierungsschicht von etwa 50 µm erzeugt werden.
- Jetten, bei dem aus einem Vorratsbehälter durch kurze Impulse Tröpfchen aus elektrisch leitfähigem Material auf den Rahmen aufgebracht werden. Nach dem Aufbringen wird das Material ausgehärtet. Dieses Verfahren ist besonders vorteilhaft, da es kontaktlos abläuft.
- Spritzen von elektrisch leitfähigem Material auf den Rahmen.

Beim Einsatz der Fototechnik wird zunächst eine flächige Metallisierung als sogenannter Seedlayer, auch als Keimschicht bezeichnet, vorzugsweise durch Sputtern vollflächig auf den Rahmen, auf die Kontaktfläche und auf die Abstrahlfläche, inklusive Kontakt, aufgebracht. Vorzugsweise werden dabei Seedlayerdicken von etwa 2 µm bis 3 µm erreicht. Als Material für den Seedlayer wird vorzugsweise eine Schichtfolge aus Titan und Kupfer verwendet. Das Titan und das Kupfer werden bevorzugt in einem Schritt aufgesputtert, wobei das Titan als Haftvermittler dient. Das Aufbringen der Kontaktstruktur auf dem Rahmen, auf der Kontaktfläche und auf dem Kontakt der Abstrahlfläche weist die folgenden Verfahrensschritte auf:
- Fotolithografie:
   Aufbringen von Fotolack durch Rotationsbeschichtung auf den gesputterten Seedlayer. Dann wird der Fotolack getrocknet. Anschließend wird der Fotolack über eine Fotomaske belichtet. Dann erfolgt eine Entwicklung des latenten Bildes, wobei die belichteten Bereiche des Fotolacks entfernt werden. Alternativ kann der Verfahrensschritt der Fotolithografie auch so ausgeführt werden, dass die belichteten Bereiche des Fotolacks nach dem Entwickeln bestehen bleiben.
- Galvanisches Verstärken oder Elektroplattieren der Kontaktstruktur. Dieser Verfahrensschritt ist notwendig, da die Stromtragfähigkeit des Seedlayers auf Grund seiner geringen Dicke zu gering wäre. Dabei erfolgt eine kontinuierliche elektrochemische Abscheidung von metallischen Niederschlägen auf dem Seedlayer, in den Bereichen, in denen beim Entwickeln der Fotolack entfernt wurde. Beim Elektroplattieren sind Dicken der Metallisierung bis zu etwa 50 µm erreichbar. Besonders vorteilhaft sind Dicken zwischen 15 µm und 30 µm. Als Metallisierungsmaterial wird vorzugsweise Kupfer verwendet.
- Entfernen des Fotolackes,
- Wegätzen des Seedlayers, der nicht von der galvanischen Verstärkung bedeckt ist. Dieser Schritt beugt einem Kurzschluss vor.

Das Herstellungsverfahren für ein optoelektronisches Modul ist besonders für eine Vielzahl von Halbleiterchips vorteilhaft, da die in dem sogenannten "Kunstwafer" vergossene Vielzahl von Halbleiterchips gleichzeitig kontaktiert werden können. Dies reduziert die Komplexität der Kontaktierung.

Dem Schritt des Aufbringens des Rahmens aus Vergussmasse geht ein Schritt des Aufbringens mindestens einer elektrischen Durchführung auf die Klebefolie voran. Dieser Schritt ist zwingend notwendig für eine serielle Verschaltung mehrerer Halbleiterchips.

In einer bevorzugten Ausführungsform weist der Schritt des Aufbringens des Rahmens aus Vergussmasse folgende Teilschritte auf:
- Formpressen (englisch Compression Molding) der Vergussmasse, die den Halbleiterchip und/oder die elektrische Durchführung zumindest bereichsweise umschließt;
- Aushärten der Vergussmasse;
- Rückschleifen der ausgehärteten Vergussmasse, derart, dass die Kontaktfläche und/oder die der Klebefolie gegenüberliegende Fläche der elektrischen Durchführung im Wesentlichen von Vergussmasse befreit wird. Diese Ausführungsform ist besonders vorteilhaft, da durch den Schritt des Rückschleifens die Halbleiterchips und die elektrischen Durchführungen auf eine einheitliche Höhe gebracht werden können. Dies reduziert die notwendige Genauigkeit bei der Bestückung der Klebefolie mit Halbleiterchips und elektrischen Durchführungen.

In einer alternativen bevorzugten Ausführungsform weist der Schritt des Aufbringens des Rahmens aus Vergussmasse folgende Teilschritte auf:
- Aufbringen einer Deckfolie, insbesondere aus Teflon, auf die Kontaktfläche und/oder auf die der Klebefolie gegenüberliegende Fläche der elektrischen Durchführung;
- Spritzgießen der Vergussmasse in einen Zwischenraum zwischen Deckfolie und Klebefolie, derart dass der Halbleiterchip und/oder die elektrische Durchführung an den Seiten, die nicht von der Klebefolie und nicht von der Deckfolie bedeckt sind, im Wesentlichen von Vergussmasse umschlossen werden;
- Aushärten der Vergussmasse;
- Entfernen der Deckfolie.

Diese alternative Ausführungsform ist besonders vorteilhaft, da beim Vergießen sowohl die Kontaktfläche als auch die Abstrahlfläche des Halbleiterchips frei von Vergussmasse bleiben. Deshalb kann der Teilschritt des Rückschleifens entfallen. Diese Ausführungsform wird auch "film assisted molding" genannt und ist ein Spezialfall des Spritzgießens (englisch Injection Molding).

In einer bevorzugten Ausführungsform folgen auf den Schritt des Aufbringens der ersten Kontaktstruktur folgende Teilschritte nach:
- Aufbringen einer elektrisch isolierenden, insbesondere dielektrischen, Schicht;
- Aufbringen einer, insbesondere metallischen, Wärmesenke.

Diese Ausführungsform ist besonders vorteilhaft, da die Wärmespreizung eine verbesserte Wärmeabfuhr von den Halbleiterchips an die Umgebungsluft ermöglicht.

In einer bevorzugten Ausführungsform folgt dem Schritt des Aufbringens der zweiten Kontaktstruktur der Schritt des Aufbringens eines Mischelements nach. Dieser Schritt ist vorteilhaft, da erst das Mischelement die räumliche Durchmischung der von den Halbleiterchips emittierten elektromagnetischen Strahlung ermöglicht.

Gemäß zumindest einer Ausführungsform des Verfahrens wird zur Bildung des optoelektronischen Moduls eine Vielzahl von Halbleiterchips bereitgestellt, die zur Emission elektromagnetischer Strahlung vorgesehen sind. Die Vielzahl von Halbleiterchips wird auf die Klebefolie aufgebracht. Die Vielzahl von Halbleiterchips wird dabei in Reihen und Spalten auf der Klebefolie angeordnet. Das heißt, im Rahmen der Herstellungstoleranz werden die Halbleiterchips beispielsweise an den Gitterpunkten eines regelmäßigen Gitters, zum Beispiel eines rechteckigen Gitters, auf der Klebefolie angeordnet.

Nachfolgend erfolgt die beschriebene Prozessierung der Anordnung aus Klebefolie und Halbleiterchips beispielsweise durch die Schritte des Aufbringens des Rahmens aus Vergussmasse sowie des Aufbringens der ersten und der zweiten Kontaktstruktur.

In zumindest einer Ausführungsform wird nach dem Aufbringen der ersten und zweiten Kontaktstrukturen, also nach dem Verdrahten der Halbleiterchips, die Anordnung aus Halbleiterchips und Rahmen durch den Rahmen hindurch zwischen den Reihen und/oder zwischen den Spalten zur Erzeugung von verkleinerten Modulen durchtrennt. Beispielsweise werden auf diese Weise lineare Module erzeugt, die sich entlang einer Reihe oder entlang einer Spalte der Halbleiterchips erstrecken. Halbleiterchips der linearen Module haben nur entlang ihrer Haupterstreckungsrichtung direkt benachbarte Halbleiterchips.

In einem weiteren Verfahrensschritt werden die verkleinerten Module auf einem Hilfsträger, beispielsweise einer weiteren Klebefolie, nebeneinander zur Bildung des optoelektronischen Moduls angeordnet. Dabei wird der Abstand zwischen den verkleinerten Modulen derart gewählt, dass der Abstand zwischen direkt benachbarten Halbleiterchips aus unterschiedlichen direkt benachbarten verkleinerten Modulen größer ist als der Abstand zwischen direkt benachbarten Halbleiterchips vor dem Durchtrennen.

Mit anderen Worten erfolgt ein Vergießen und Verdrahten der Halbleiterchips bei diesem Verfahren für Halbleiterchips, die relativ dicht nebeneinander angeordnet sind. Der Abstand zwischen den Halbleiterchips wird dann in zumindest einer Richtung durch das Durchtrennen in verkleinerte Module und das Anordnen der verkleinerten Module mit größerem Abstand zueinander vergrößert.

Nachfolgend kann ein weiteres Vergießen der kleineren Module auf dem Hilfsträger beispielsweise mit einer reflektierenden oder einer strahlungsdurchlässigen Vergussmasse erfolgen.

Dem Verfahren liegt dabei unter anderem die Erkenntnis zugrunde, dass eine flächige Anordnung von Halbleiterchips, die nicht sehr dicht mit den Halbleiterchips belegt ist, hohe Kosten bei der Verdrahtung der Halbleiterchips erzeugt. Bei dem Verfahren werden die Halbleiterchips daher in einem Zustand verdrahtet, in dem sie noch dicht nebeneinander liegen. In einem nächsten Verfahrensschritt werden die Abstände der Halbleiterchips in zumindest einer Richtung derart vergrößert, dass vom Modul Licht mit der gewünschten Abstrahlcharakteristik bei Betrieb der Halbleiterchips erzeugt wird. Dazu werden beispielsweise lineare Module oder Barren durch das Durchtrennen erzeugt und auf dem Hilfsträger anschließend gegebenenfalls erneut vergossen.

Alternativ oder zusätzlich können weitere hier beschriebene Verfahrensschritte wie beispielsweise das Aufbringen eines Mischelements zur räumlichen Durchmischung und das Aufbringen einer strukturierten Spiegelschicht oder einer strukturierten Streuschicht zwischen dem Mischelement und dem Rahmen erfolgen. Verschiedene Ausführungsbeispiele werden im Folgenden anhand der Zeichnungen näher erläutert. Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und zum besseren Verständnis übertrieben groß oder verkleinert dargestellt sein.
- Figur 1a: zeigt ein erstes Beispiel eines optoelektronischen Moduls in Schnittansicht;
- Figur 1b: zeigt das optoelektronische Modul aus Figur 1a in Draufsicht;
- Figur 2: zeigt einen ersten Halbleiterchip in Schnittansicht;
- Figur 3: zeigt einen zweiten Halbleiterchip in Schnittansicht;
- Figur 4a: zeigt ein zweites Ausführungsbeispiel eines optoelektronischen Moduls in Schnittansicht;
- Figur 4b: zeigt das optoelektronische Modul aus Figur 4a in Draufsicht;
- Figur 5: zeigt die Schritte des erfindungsgemäßen Herstellungsverfahrens;
- Figur 6: zeigt das Zwischenprodukt nach Ausführung des Schritts S1 des Herstellungsverfahrens in Schnittansicht;
- Figur 7: zeigt das alternative Zwischenprodukt nach Ausführung des Schritts S1 des Herstellungsverfahrens in Schnittansicht;
- Figur 8: zeigt die Anordnung bei der Ausführung des Schritts S2A des Herstellungsverfahrens in Schnittansicht;
- Figur 9: zeigt die Anordnung bei der Ausführung des zu S2A alternativen Schritts S2B des Herstellungsverfahrens in Schnittansicht;
- Figur 10: zeigt das Zwischenprodukt nach Ausführung des Schritts S2A oder S2B des Herstellungsverfahrens in Schnittansicht;
- Figur 11: zeigt das Zwischenprodukt nach Ausführung des Schritts S3 des Herstellungsverfahrens in Schnittansicht;
- Figur 12: zeigt das Zwischenprodukt nach Ausführung des optionalen Schritts S4 des Herstellungsverfahrens in Schnittansicht;
- Figur 13: zeigt das Zwischenprodukt nach Ausführung des Schritts S5 des Herstellungsverfahrens in Schnittansicht;
- Figur 14: zeigt das alternative Zwischenprodukt nach Ausführung des Schritts S5 des Herstellungsverfahrens in Schnittansicht;
- Figur 15a: zeigt ein drittes Ausführungsbeispiel eines erfindungsgemäßen optoelektronischen Moduls in Schnittansicht nach Ausführung des Schritts S6 des Herstellungsverfahrens;
- Figur 15b: zeigt das erfindungsgemäße optoelektronische Modul aus Figur 15a in Draufsicht;
- Figur 16a: zeigt ein viertes Ausführungsbeispiel eines erfindungsgemäßen optoelektronischen Moduls in Schnittansicht nach Ausführung des Schritts S6 des Herstellungsverfahrens;
- Figur 16b: zeigt das erfindungsgemäße optoelektronische Modul aus Figur 16a in Draufsicht;
- Figur 17: zeigt ein fünftes Ausführungsbeispiel eines erfindungsgemäßen optoelektronischen Moduls in Schnittansicht nach Ausführung des optionalen Schritts S7 des Herstellungsverfahrens;
- Figur 18: zeigt ein sechstes Ausführungsbeispiel eines erfindungsgemäßen optoelektronischen Moduls in Schnittansicht nach Ausführung des optionalen Schritts S7 des Herstellungsverfahrens;
- Figur 19: zeigt ein siebtes Ausführungsbeispiel eines erfindungsgemäßen optoelektronischen Moduls in Schnittansicht nach Ausführung des optionalen Schritts S7 des Herstellungsverfahrens;
- Figur 20: zeigt ein Ersatzschaltbild für seriell verschaltete Halbleiterchips;
- Figur 21: zeigt ein achtes Ausführungsbeispiel eines erfindungsgemäßen optoelektronischen Moduls in Schnittansicht nach Ausführung des Schritts S6 des Herstellungsverfahrens;
- Figur 22: zeigt ein Ersatzschaltbild für parallel verschaltete Halbleiterchips;
- Figuren 23A, 23B, 23C: zeigen anhand schematischer Aufsichten weitere Verfahrensschritte eines hier beschriebenen Verfahrens.

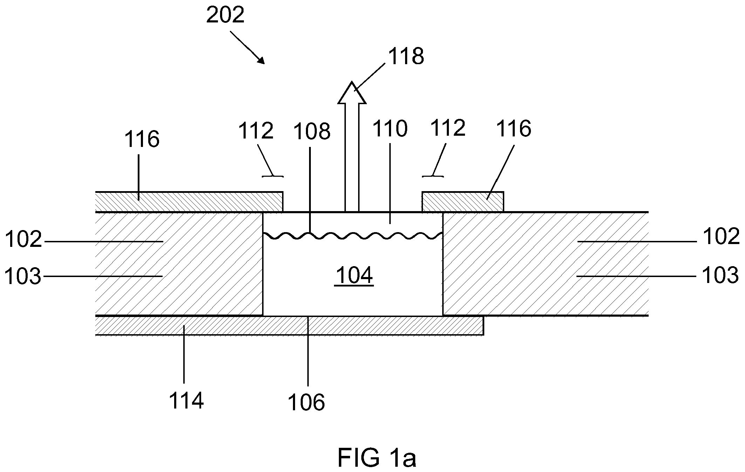

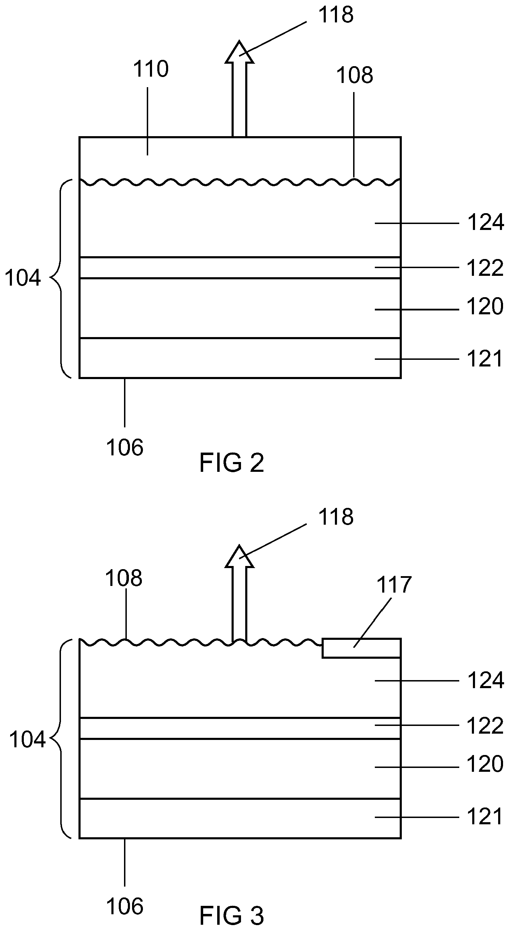

Figur 1a zeigt ein erstes Beispiel eines optoelektronischen Moduls 202 in Schnittansicht. Dieses Modul 202 weist einen Halbleiterchip 104 zur Emission elektromagnetischer Strahlung 118 auf. Der Halbleiterchip 104 weist eine Mehrzahl von Epitaxieschichtenfogen auf (nicht in Figur 1a gezeigt; siehe Figur 2 und 3). Der Halbleiterchip weist eine Abstrahlfläche 108 auf, die definiert ist als die Fläche der Epitaxieschichten, an der die elektromagnetische Strahlung 118 aus dem Halbleiterchip 104 austritt. Die Abstrahlfläche 108 weist eine Auskoppelstruktur (als Wellenlinie dargestellt) auf, die die Auskoppeleffizienz der elektromagnetischen Strahlung 118 aus dem Halbleiterchip 104 über die Abstrahlfläche 108 erhöht. Auf der Abstrahlfläche 108 ist ein erster Kontakt angeordnet, der als transparente Kontaktschicht 110 ausgebildet ist. Transparent bedeutet vorliegend, dass elektromagnetische Strahlung aus dem sichtbaren Spektralbereich ohne wesentliche Absorptionsverluste die Kontaktschicht 110 durchläuft. Die transparente Kontaktschicht 110 bedeckt die Abstrahlfläche 108 vollflächig. In einem nicht gezeigten alternativen Beispiel kann die transparente Kontaktschicht 110 die Abstrahlfläche 108 nur bereichsweise bedecken. Der Abstrahlfläche 108 liegt eine Kontaktfläche 106 des Halbleiterchips 104 gegenüber. Die Kontaktfläche 106 dient als zweiter elektrischer Kontakt des Halbleiterchips 104. Ein Rahmen 103 aus Vergussmasse 102 umschließt den Halbleiterchip 104 seitlich vollständig. Die Vergussmasse 102 schließt im Wesentlichen bündig mit der dem Halbleiterchip 104 abgewandten Oberfläche der transparenten Kontaktschicht 110 und mit der Kontaktschicht 106 ab. Die Abstrahlfläche 108, genauer gesagt die transparente Kontaktschicht 110, und die Kontaktfläche 106 sind frei von Vergussmasse 102. Das bündige Abschließen der Vergussmasse 102 ist vorteilhaft, da auf solch plane Strukturen besonders einfach stabile Kontaktstrukturen aufgebracht werden können. In einem nicht in den Figuren dargestellten Beispiel umschließt die Vergussmasse 102 die Seitenflächen des Halbleiterchips 104 nur bereichsweise. Auch kann an der Grenze von Kontaktfläche 106 zu Vergussmasse 102 und/oder an der Grenze von transparenter Kontaktschicht 110 zu Vergussmasse 102 eine Stufe ausgebildet sein.

In Figur 1a ist eine erste Kontaktstruktur 114 zumindest bereichsweise auf dem Rahmen 103 und zumindest bereichsweise auf der Kontaktfläche 106 angeordnet. Die erste Kontaktstruktur 114 dient zur elektrischen Kontaktierung einer Schicht einer ersten Leitfähigkeit (nicht in Figur 1a gezeigt; siehe Figur 2 und 3) des Halbleiterchips 104. Eine zweite Kontaktstruktur 116 ist flächig auf dem Rahmen 103 und bereichsweise auf der transparenten Kontaktschicht 110 angeordnet. Die zweite Kontaktstruktur 116 dient zur elektrischen Kontaktierung einer Schicht einer zweiten Leitfähigkeit (nicht in Figur 1a gezeigt; siehe Figuren 2 und 3) des Halbleiterchips 104. Die zweite Kontaktstruktur 116 weist einen Überlappungsbereich 112 über den Rand der transparenten Kontaktschicht 110 von beispielsweise 5 µm auf. Durch den Überlappungsbereich 112 ist die zweite Kontaktstruktur 116 in mechanischem und elektrischem Kontakt mit der transparenten Kontaktschicht 110, die die Abstrahlfläche 108 vollflächig bedeckt. Ein Überlappungsbereich von nur wenigen µm ist vorteilhaft, da nur ein kleiner Teil der Abstrahlfläche 108 und der transparenten Kontaktschicht 110 abgeschattet ist. Es kann deshalb selbst bei kleinen Halbleiterchips 104 mit Kantenlängen von beispielsweise nur 50 µm eine hohe Auskoppeleffizienz für die elektromagnetische Strahlung 118 aus dem Halbleiterchip 104 erreicht werden. Die transparente Kontaktschicht 110 weist beispielsweise Indiumzinnoxid (englisch Indium Tin Oxide (ITO)) oder Zinkoxid auf.

Die erste Kontaktstruktur 114 ist auf der Seite des Rahmens 103, die an die Kontaktfläche 106 angrenzt, aufgebracht. Die zweite Kontaktstruktur 116 ist auf der Seite des Rahmens 103, die an die Abstrahlfläche 108 und an die transparente Kontaktschicht 110 angrenzt, aufgebracht.

Die Vergussmasse 102 weist als Wirtsmaterial wenigstens eines der folgenden Materialien auf:
- Silikon
- Epoxydharz
- Hybridmaterialien.

In die Vergussmasse 102 können Partikel dispergiert sein, die wenigstens eines der folgenden Materialien aufweisen:
- Titandioxid (TiO₂),
- Aluminiumoxid (Al₂O₃),
- Zirkoniumoxid (ZrO),
- Bariumdifluorid (BaF₂)
- Siliziumdioxid (SiO₂)
- Ruß.

Die Partikel sind nicht in Figur 1a dargestellt.

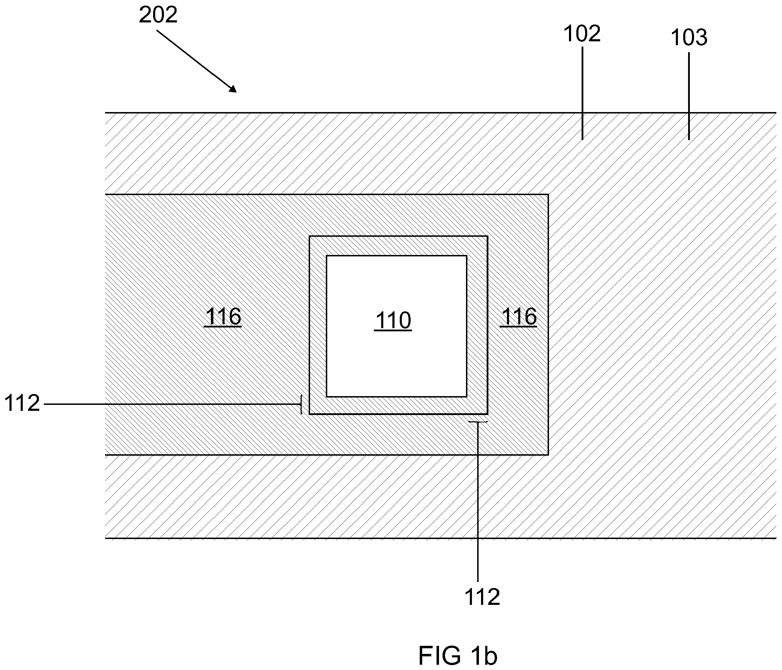

Figur 1b zeigt das optoelektronische Modul aus Figur 1a in Draufsicht. Die zweite Kontaktstruktur 116 umschließt die transparente Kontaktschicht 110 an allen vier Seiten. Dies ermöglicht eine gleichmäßige Bestromung des Halbleiterchips 104 über die Kontaktschicht 110. Die zweite Kontaktstruktur 116 weist an allen vier Seiten der transparenten Kontaktschicht 110 einen Überlappungsbereich 112 mit der transparenten Kontaktschicht 110 auf. Die zweite Kontaktstruktur 116 weist eine Breite auf, die größer ist als die Breite der transparenten Kontaktschicht 110. In einem nicht gezeigten Beispiel kann die zweite Kontaktstruktur 116 nur eine, zwei oder drei Seiten der transparenten Kontaktschicht 110 kontaktieren. Insbesondere für kleine Halbleiterchips 104, im Wesentlichen mit Kantenlängen kleiner als 200 µm, kann dies für die Bestromung ausreichend sein.

Figur 2 zeigt einen ersten Halbleiterchip 104 in Schnittansicht. Der Halbleiterchip 104 weist ein elektrisch leitfähiges Substrat 121 auf, das an einer Grundfläche mit einer Kontaktfläche 106 abschließt. Das Substrat 121 kann beispielsweise Germanium oder Silizium aufweisen. Das Substrat 121 dient als Kontaktierungs- und Befestigungsmittel für nachfolgende Epitaxieschichten des Halbleiterchips 104 und wird in der vorliegenden Anmeldung als Teil des Halbleiterchips 104 betrachtet. Dem Substrat 121 ist eine Schicht einer ersten Leitfähigkeit 120, insbesondere einer p-Leitfähigkeit, nachgeordnet. Der Schicht einer ersten Leitfähigkeit ist eine aktive Zone 122 nachgeordnet. Der aktiven Zone 122 ist eine Schicht einer zweiten Leitfähigkeit 124, insbesondere einer n-Leitfähigkeit, nachgeordnet. Alternativ kann die Schicht einer ersten Leitfähigkeit 120 n-leitend und die Schicht einer zweiten Leitfähigkeit 124 p-leitend sein. Die Schicht einer ersten Leitfähigkeit 120, die aktive Zone 122 und die Schicht einer zweiten Leitfähigkeit 124 sind epitaktisch aufeinander aufgewachsen.

Die elektromagnetische Strahlung 118 verlässt den Halbleiterchip 104 über die Abstrahlfläche 108. Die Abstrahlfläche 108 weist eine Auskoppelstruktur auf, die in Figur 2 als gewellte Linie dargestellt ist. Die Auskoppelstruktur kann beispielsweise eine Pyramidenstruktur aufweisen, was der Übersichtlichkeit halber nicht detailliert in Figur 2 dargestellt ist. Die Abstrahlfläche 108 ist vollflächig mit einer elektrisch leitfähigen, transparenten Kontaktschicht 110, beispielsweise aus Indiumzinnoxid (englisch ITO), bedeckt. Nach dem Austritt aus der Abstrahlfläche 108 durchläuft die elektromagnetische Strahlung 118 die transparente Kontaktschicht 110. Die Absorption der elektromagnetischen Strahlung 118 in der transparenten Kontaktschicht 110 ist bei geeigneter Materialwahl ausreichend gering. Die transparente Kontaktschicht 110 wird in der vorliegenden Anmeldung nicht als Bestandteil des Halbleiterchips 104 betrachtet.

Figur 3 zeigt einen zweiten Halbleiterchip 104 in Schnittansicht. Der Halbleiterchip 104 in Figur 3 entspricht im Wesentlichen dem Halbleiterchip in Figur 2, außer: Ein Kontaktpad 117 ist unmittelbar auf der Abstrahlfläche 108 des Halbleiterchips 104 aufgebracht. Das Kontaktpad 117 wird in der vorliegenden Anmeldung nicht als Bestandteil des Halbleiterchips 104 betrachtet. Das Kontaktpad 117 weist ein elektrisch leitfähiges Metall oder eine metallische Legierung auf. Das Kontaktpad 117 hat die gleiche Funktion wie die transparente Kontaktschicht 110 aus Figur 2, also die Bestromung der Schicht einer zweiten Leitfähigkeit 124.

Das Kontaktpad 117 bedeckt beispielsweise weniger als 30 %, vorzugsweise weniger als 15 % der Abstrahlfläche 108.

Die Kantenlänge der Abstrahlfläche 108 des Halbleiterchips 104 in Figur 2 und Figur 3 kann zwischen etwa 50 µm und etwa 1000 µm betragen.

Je kleiner der Halbleiterchip 104 desto kleiner sollte das Kontaktpad 117 auf der Abstrahlfläche 108 gewählt werden, um die Abschattung der elektromagnetischen Strahlung 118 durch das Kontaktpad 117 zu minimieren.

In der in Figur 2 und Figur 3 dargestellten aktiven Zone 122 wird die elektromagnetische Strahlung 118 erzeugt. Die aktive Zone 122 kann ein pn-Übergang, eine Doppelheterostruktur, eine Mehrfach-Quantentopfstruktur (MQW) oder eine Einfach-Quantentopfstruktur (SQW) sein. Quantentopfstruktur bedeutet: Quantentöpfe (3-dim), Quantendrähte (2-dim) und Quantenpunkte (1-dim).

Der Halbleiterchip 104, genauer gesagt der epitaktisch aufeinander aufgewachsene Schichtstapel mit der Schicht einer ersten Leitfähigkeit 120, der aktiven Zone 122 und der Schicht einer zweiten Leitfähigkeit 124, kann auf einem III-V-Verbindungshalbleitermaterial basieren. III-V-Verbindungshalbleitermaterialen sind vorteilhaft, da bei der Strahlungserzeugung hohe interne Quanteneffizienzen erzielt werden können.

Der Halbleiterchip 104 weist beispielsweise Aluminiumindiumgalliumnitrid (AlₓIn_{y}Ga_{1-x-y}N) auf. Hierbei gilt 0≤x≤1, 0≤y≤1 und x+y≤1, insbesondere mit x≠1, y≠1, x≠0 und/oder y≠0. Dieser Halbleiterchip 104 kann elektromagnetische Strahlung 118 vom ultravioletten Spektralbereich über den blauen Spektralbereich bis zum grünen Spektralbereich emittieren.

Der Halbleiterchip 104 weist beispielsweise Aluminiumindiumgalliumphosphid (AlₓIn_{y}Ga_{1-x-y}P) auf. Hierbei gilt 0≤x≤1, 0≤y≤1 und x+y≤1, insbesondere mit x≠1, y≠1, x≠0 und/oder y≠0. Dieser Halbleiterchip 104 kann elektromagnetische Strahlung 118 vom roten Spektralbereich bis zum gelben Spektralbereich emittieren.

Beispielsweise kann der Halbleiterchip 104 als Oberflächenemitter, insbesondere als sogenannter Dünnfilmchip, ausgebildet sein. Der Einsatz eines Oberflächenemitters ist besonders vorteilhaft, da sein Licht besonders effizient in nachgeordnete optische Elemente, wie zum Beispiel in Mischelemente, einkoppelbar ist. Der Dünnfilmchip ist beispielsweise aus der Offenlegungsschrift WO 2005081319 A1 bekannt, deren Offenbarung hiermit durch Rückbezug in die Offenbarung der vorliegenden Anmeldung aufgenommen wird.

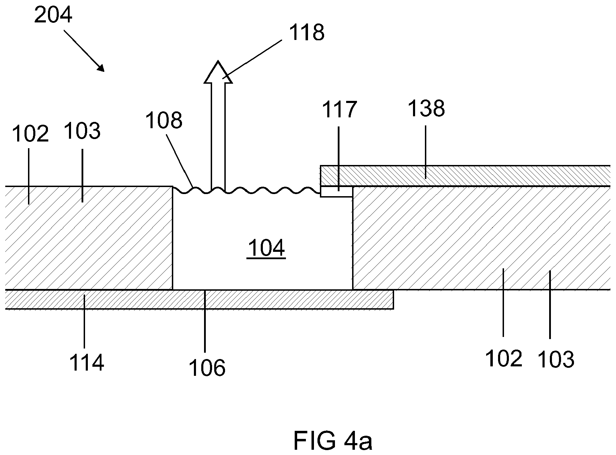

Figur 4a zeigt ein zweites Beispiel eines optoelektronischen Moduls 204 in Schnittansicht. Das Beispiel in Figur 4a unterscheidet sich vom Beispiel in Figur 1a nur durch die Art der Kontaktierung der Schicht einer zweiten Leitfähigkeit (nicht in Figur 4a gezeigt). Im Übrigen gelten die Ausführungen in Bezug auf das erste Beispiel in Figur 1a. Anstelle der transparenten Kontaktschicht 110 in Figur 1a ist in Figur 4a auf der Abstrahlfläche 108 ein Kontaktpad 117 aufgebracht. Das Kontaktpad 117 wird durch eine zweite Kontaktstruktur in Form einer planaren Kontaktschicht 138 elektrisch leitend kontaktiert. Der Begriff der planaren Kontaktschicht 138 wird vorliegend als Abgrenzung zum herkömmlichen Drahtbonden verwendet. Im Gegensatz zu einem Bonddraht hat die planare Kontaktschicht 138 eine flächige Ausprägung.

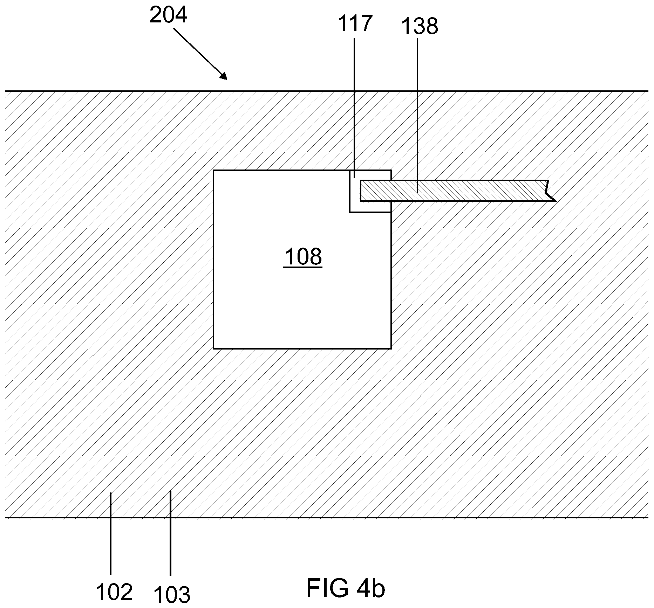

Figur 4b zeigt das optoelektronische Modul 204 aus Figur 4a in Draufsicht. Das Kontaktpad 117 ist unmittelbar auf der Abstrahlfläche 108 aufgebracht. Das Kontaktpad 117 wird über die planare Kontaktschicht 138 elektrisch kontaktiert. Die planare Kontaktschicht 138 hat im vorliegenden Beispiel die gleiche Funktion wie die zweite Kontaktstruktur 116 im Beispiel von Figur 1b. Die planare Kontaktschicht 138 kann die Form eines länglichen Streifens aufweisen. Die planare Kontaktschicht 138 weist eine Erstreckung (Breite) senkrecht zu Ihrer Haupterstreckungsrichtung von 5 µm bis 150 µm, vorzugsweise von 10 µm bis 50 µm, auf. Die zu wählende Breite der planaren Kontaktschicht 138 ist abhängig von der Größe des Kontaktpads 117, das kontaktiert werden soll und von der notwendigen Stromtragfähigkeit. Die planare Kontaktschicht 138 kann beispielsweise eine Dicke von 5 µm bis 60 µm, vorzugsweise von 15 µm bis 25 µm, aufweisen.

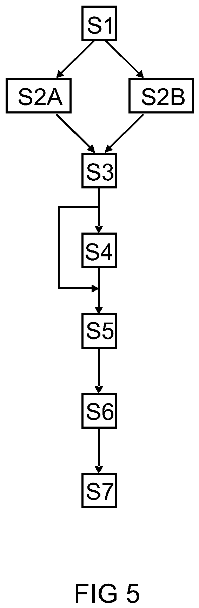

Figur 5 zeigt die Schritte S1 bis S7 des erfindungsgemäßen Verfahrens zur Herstellung eines optoelektronischen Moduls.

Im Schritt S1 wird mindestens ein Halbleiterchip 104 zur Emission elektromagnetischer Strahlung 118 auf eine Klebefolie 132 aufgebracht. Der Halbleiterchip 104 weist eine Abstrahlfläche 108 und eine der Abstrahlfläche 108 gegenüberliegende Kontaktfläche 106 auf. Auf der Abstrahlfläche 108 ist in Abstrahlrichtung eine transparente Kontaktschicht 110 aufgebracht. Beim Aufbringen weist die Abstrahlfläche 108 des Halbleiterchips 104 und damit auch die transparente Kontaktschicht 110 zur Klebefolie 132. Es wird mindestens eine elektrische Durchführung 130, beispielsweise aus Kupfer oder Silizium, auf die Klebefolie 132 aufgebracht. In einem nicht gezeigten Ausführungsbeispiel kann auf die elektrischen Durchführungen 130 verzichtet werden.

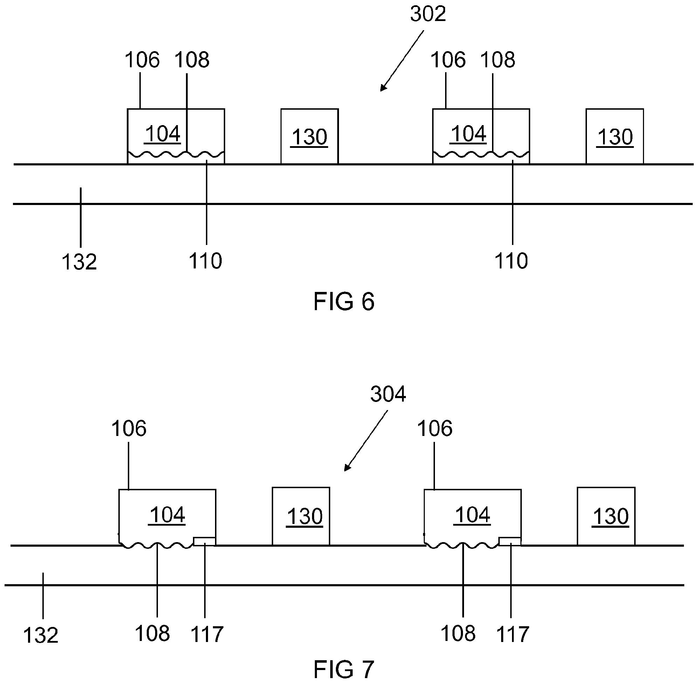

In Figur 6 ist das Zwischenprodukt 302 nach Ausführung des Schrittes S1 dargestellt. Die den beiden Halbleiterchips 104 in Abstrahlrichtung nachgeordneten transparenten Kontaktschichten 110 haften mit ihren planen Oberflächen unmittelbar auf der Klebefolie 132. Dadurch sind die beiden Halbleiterchips 104 für die nachfolgenden Schritte des Herstellungsverfahrens auf der Klebefolie 132 mechanisch fixiert. Ebenso sind zwei elektrische Durchführungen 130 auf der Klebefolie 132 angeordnet. In nicht dargestellten Ausführungsbeispielen weist das Zwischenprodukt des Schrittes S1 einen einzelnen Halbleiterchip 104 oder eine Vielzahl von Halbleiterchips 104 auf. In nicht dargestellten Ausführungsbeispielen weist das Zwischenprodukt des Schrittes S1 keine, eine oder eine Vielzahl von elektrischen Durchführungen 130 auf.

In Figur 7 ist das zu Figur 6 alternative Zwischenprodukt 304 nach Ausführung des Schrittes S1 dargestellt. Es sind zwei Halbleiterchips 104 und zwei elektrische Durchführungen 130 auf der Klebefolie 132 fixiert. Die Abstrahlflächen 108 und die Kontaktpads 117 sind in direktem Kontakt mit der Klebefolie 132. In nicht dargestellten Ausführungsbeispielen weist das Zwischenprodukt des Schrittes S1 einen einzelnen Halbleiterchip 104 oder eine Vielzahl von Halbleiterchips 104 auf. In nicht dargestellten Ausführungsbeispielen weist das Zwischenprodukt des Schrittes S1 keine, eine oder eine Vielzahl von elektrischen Durchführungen 130 auf.

Im Schritt S1 werden die Halbleiterchips 104 und die elektrischen Durchführungen 130 lediglich auf der Klebefolie 132 abgelegt. Es ist kein separates Kleben oder Löten der Halbleiterchips 104 und der elektrischen Durchführungen 130 auf einen Träger notwendig.

Im Schritt S2 wird ein Rahmen 103 aus Vergussmasse 102 derart auf die freiliegenden Bereiche der Klebefolie 132 aufgebracht, dass die Halbleiterchips 104 seitlich zumindest bereichsweise von Vergussmasse 102 umschlossen werden. Die Kontaktflächen 106 und die Abstrahlflächen 108 beziehungsweise die transparenten Kontaktschichten 110 der Halbleiterchips 104 sind im Wesentlichen von Vergussmasse 102 befreit. Der Schritt S2 kann mit zwei verschiedenen Verfahren S2A oder S2B ausgeführt werden und führt zum gleichen Zwischenprodukt 310.

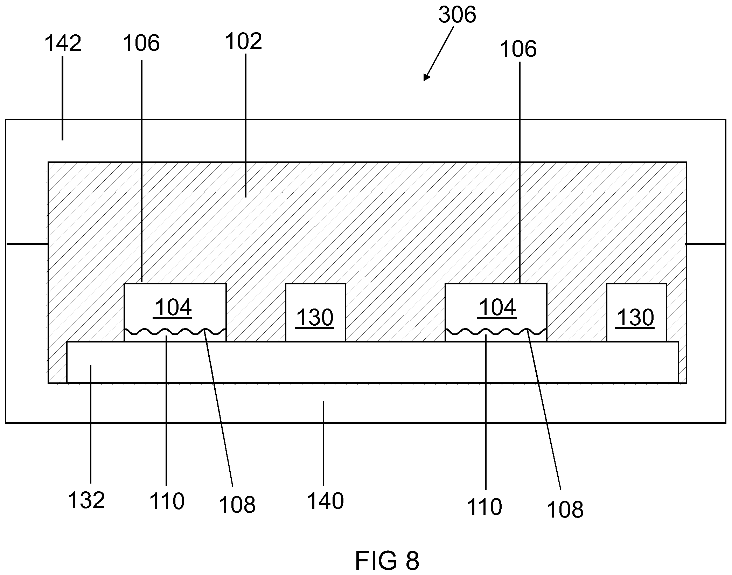

In der Variante S2A wird Vergussmasse 102, die die Halbleiterchips 104 und/oder die elektrischen Durchführungen 130 zumindest bereichsweise umschließt, formgepresst. In Figur 8 ist die Anordnung bei Ausführung des Schrittes S2A in Schnittansicht gezeigt. Diese Anordnung wird als Zwischenprodukt 306 bezeichnet. Es ist der Schritt des Formpressens (englisch Compression Molding) veranschaulicht. Die Basis der Moldform 140 umschließt die Klebefolie 132, auf die die beiden Halbleiterchips 104 und die beiden elektrischen Durchführungen 130 aufgeklebt sind. Der Deckel der Moldform 142 bildet mit der Basis 140 einen Hohlraum, der mit Vergussmasse 102, beispielsweise mit Silikon, gefüllt ist. Die Vergussmasse 102 umschließt die nicht von der Klebefolie 132 bedeckten Flächen der Halbleiterchips 104 und der elektrischen Durchführungen 130 vollständig. Nach dem Schritt des Pressens wird die Vergussmasse 102 ausgehärtet. Das Aushärten kann durch ein Einwirken von thermischer Energie oder durch eine Einstrahlung von elektromagnetischer Strahlung, insbesondere aus dem UV-Bereich, erfolgen. Anschließend wird die ausgehärtete Vergussmasse 102 derart zurückgeschliffen, dass die Kontaktflächen 106 der beiden Halbleiterchips 104 und die der Klebefolie 132 gegenüberliegenden Flächen der beiden elektrischen Durchführungen 130 im Wesentlichen von Vergussmasse 102 befreit werden.

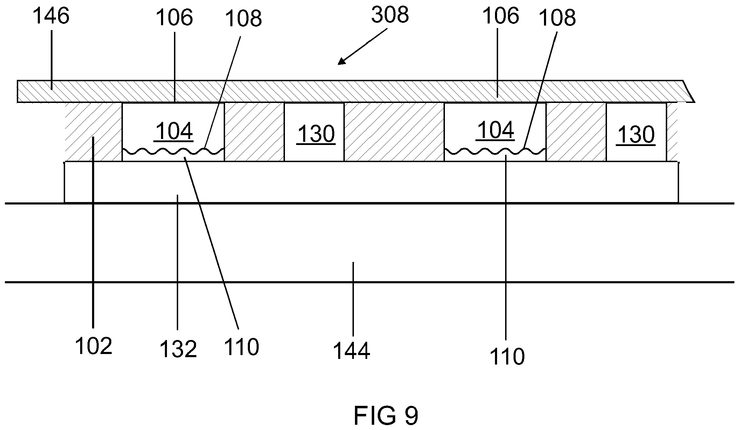

In der Variante S2B wird die Vergussmasse 102 durch Spritzgießen (englisch Injection Molding) eingebracht. Figur 9 zeigt die Anordnung bei der Ausführung des alternativen Schrittes S2B in Schnittansicht. Diese Anordnung wird als Zwischenprodukt 308 bezeichnet. Es ist der Schritt des Spritzgießens veranschaulicht. Die Klebefolie 132 mit den beiden Halbleiterchips 104 und den beiden elektrischen Durchführungen 130 wird auf einem Träger 144 einer Moldform angeordnet. Anschließend wird eine Deckfolie 146, beispielsweise aus Teflon, auf die Kontaktfläche 106 der beiden Halbleiterchips 104 und auf die der Klebefolie 132 gegenüberliegenden Flächen der beiden elektrischen Durchführungen 130 aufgebracht. Anschließend wird Vergussmasse 102 in den Zwischenraum zwischen Deckfolie 146 und Klebefolie 132 gespritzt, derart dass die Halbleiterchips 104 und die elektrischen Durchführungen 130 an den Seiten, die nicht von der Klebefolie 132 und nicht von der Deckfolie 146 bedeckt sind, vollständig von Vergussmasse 102 umschlossen werden. Anschließend wird die Vergussmasse 102 ausgehärtet. Abschließend wird die Deckfolie 146 entfernt. Diesen Spezialfall des Spritzgießens nennt man auch Film unterstütztes Formpressen (englisch "Film Assisted Molding").

Die Klebefolie 132 ist beispielsweise eine Kunststofffolie, die auf beiden Seiten haftend ist. Die Seite der Klebefolie 132, auf die die Halbleiterchips 104 und die elektrischen Durchführungen 130 aufgebracht sind, bleibt bei allen vorkommenden Temperaturen haftend. Die Seite der Klebefolie 132, die zum metallischen Träger 140, 144 des Moldwerkzeuges weist, verliert ihre Haftkraft ab einer bestimmten Temperatur (englisch Thermo Release). Die Klebefolie 132 löst sich also ab einer bestimmten Temperatur selbständig vom Träger 140, 144 des Moldwerkzeuges ab.

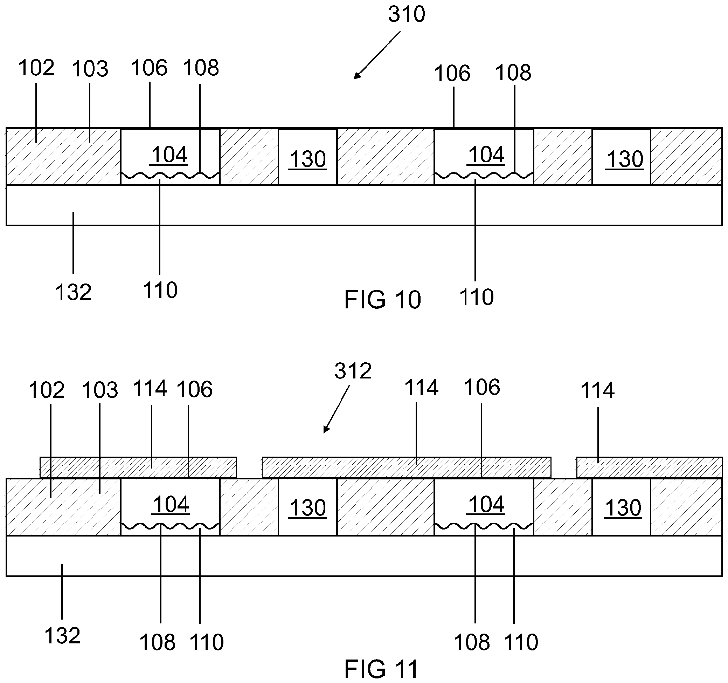

Figur 10 zeigt das Zwischenprodukt 310 nach Ausführung des Schrittes S2A oder S2B in Schnittansicht. Die beiden Halbleiterchips 104 und die beiden elektrischen Durchführungen 130 sind an ihren Seitenflächen vollständig von ausgehärteter Vergussmasse 102 umgeben. Die ausgehärtete Vergussmasse 102 bildet einen Rahmen 103 um die beiden Halbleiterchips 104 und um die beiden elektrischen Durchführungen 130. Der Rahmen 103 schließt bündig mit den Kontaktflächen 106 der Halbleiterchips 104 und mit den Flächen der elektrischen Durchführungen 130, die der Klebefolie 132 gegenüberliegen, ab. In einem nicht gezeigten Zwischenprodukt kann zwischen dem Rahmen 103 und den Kontaktflächen 106 und/oder zwischen dem Rahmen 103 und den Flächen der elektrischen Durchführungen 130, die der Klebefolie gegenüberliegen, eine Stufe ausgebildet sein. Die Kontaktflächen 106 der Halbleiterchips 104 und die der Klebefolie 132 gegenüberliegenden Flächen der elektrischen Durchführungen sind vollständig von Vergussmasse 102 befreit. Das Zwischenprodukt 310 ergibt sich unabhängig davon, ob der Verfahrensschritt S2 gemäß der Variante S2A oder der Variante S2B ausgeführt wurde.

Im Schritt S3 wird eine erste Kontaktstruktur 114 auf die der Klebefolie 132 gegenüberliegende Fläche des Rahmens 103, auf die Kontaktflächen 106 der Halbleiterchips 104 und auf die der Klebefolie 132 gegenüberliegenden Flächen der elektrischen Durchführungen 130 aufgebracht. Die erste Kontaktstruktur 114 kann beispielsweise durch Fotolithografie, Siebdrucken oder Jetten aufgebracht werden. Die Kontaktstruktur 114 weist beispielsweise ein Metall, wie Kupfer, oder eine metallische Legierung auf. Figur 11 zeigt das Zwischenprodukt 312 nach Ausführen des Schrittes S3 in Schnittansicht. Die erste Kontaktstruktur 114 verbindet jeweils die Kontaktfläche 106 eines Halbleiterchips 104 mit einer elektrischen Durchführung 130.

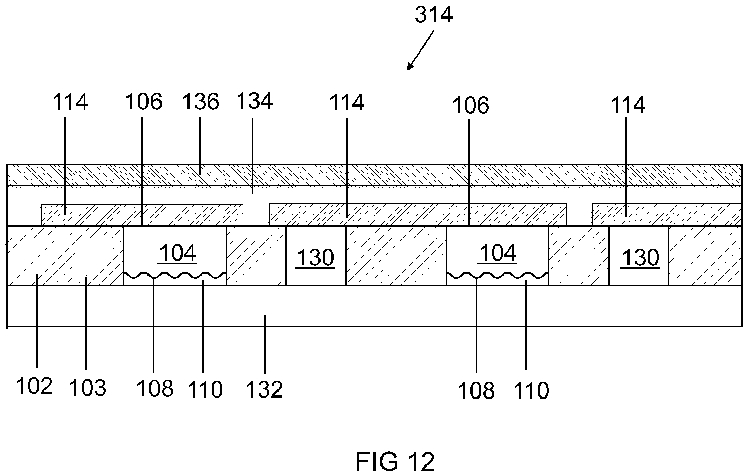

Im optionalen Schritt S4 wird eine elektrisch isolierende, insbesondere dielektrische, Schicht 134 auf die erste Kontaktstruktur 114 und auf die nicht von der ersten Kontaktstruktur 114 bedeckten Bereiche der Seite des Rahmens 103 aus Vergussmasse 102, die der Klebefolie 132 gegenüberliegt, aufgebracht. Anschließend wird eine, insbesondere metallische, Wärmesenke 136 auf die elektrisch isolierende Schicht 134 aufgebracht. Figur 12 zeigt das Zwischenprodukt 314 nach Ausführen des optionalen Schrittes S4.

In Figur 8, 9, 10, 11 und 12 sind nur Halbleiterchips 104 dargestellt, die als Kontakt auf der Abstrahlfläche 108 eine transparente Kontaktschicht 110 aufweisen. Das Herstellungsverfahren verläuft jedoch identisch, wenn statt der transparenten Kontaktschicht 110 ein Kontaktpad 117 als Kontakt auf der Abstrahlfläche 108 aufgebracht ist.

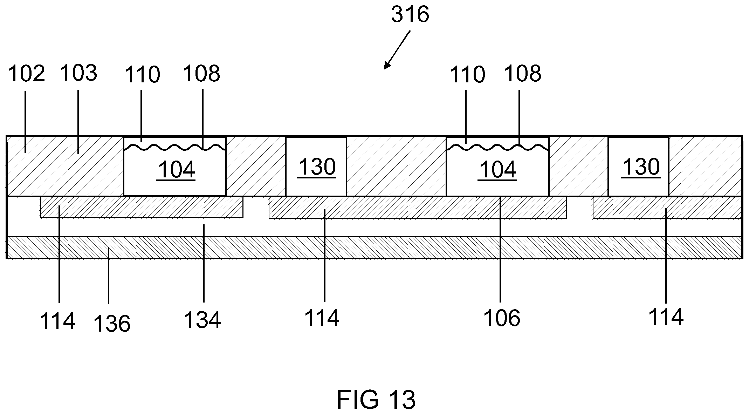

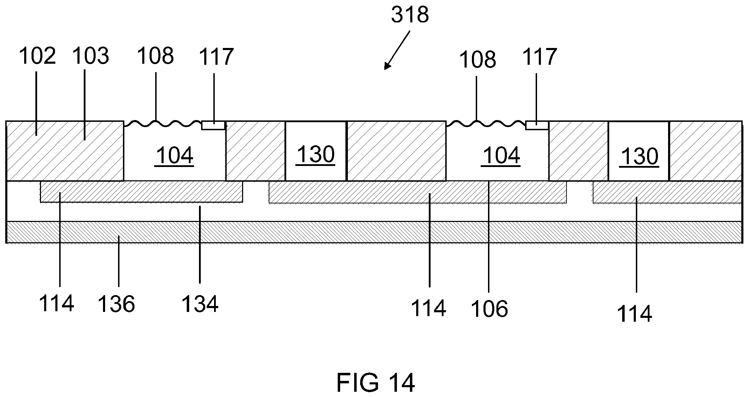

Im Schritt S5 wird die Klebefolie 132 entfernt. Beispielsweise kann die Klebefolie 132 durch einfaches Abziehen entfernt werden. Figur 13 und Figur 14 zeigen das Zwischenprodukt 316 und 318 nach Ausführen des Schrittes S5 in Schnittansicht. In Figur 13 sind Halbleiterchips 104 dargestellt, deren Abstrahlfläche 108 vollständig mit der transparenten Kontaktschicht 110 bedeckt ist. Die transparente Kontaktschicht 110 ist vollständig von Vergussmasse 102 befreit. In Figur 14 sind Halbleiterchips 104 dargestellt, bei denen das Kontaktpad 117 direkt auf die Abstrahlfläche 108 aufgebracht ist. Das Kontaktpad 117 und die Abstrahlfläche 108 sind vollständig von Vergussmasse 102 befreit. Zudem zeigen Figur 13 und 14 elektrische Durchführungen 130, deren Flächen, die der ersten Kontaktstruktur 114 gegenüberliegen, vollständig von Vergussmasse 102 befreit sind. Dadurch sind die Halbleiterchips 104 und die elektrischen Durchführungen 130 für das Aufbringen einer zweiten Kontaktstruktur 116 ausgelegt.

Im Schritt S6 wird eine zweite Kontaktstruktur 116, 138 auf den Rahmen 103 aus Vergussmasse 102, auf die Kontakte 110, 117 auf der Abstrahlfläche 108 zur elektrischen Kontaktierung einer Schicht einer zweiten Leitfähigkeit (nicht in 15a gezeigt) der Halbleiterchips 104 und auf die elektrischen Durchführungen 130 aufgebracht. Die zweite Kontaktstruktur 116 kann beispielsweise ein Metall, wie Kupfer, oder eine metallische Legierung aufweisen. Die zweite Kontaktstruktur 116 kann beispielsweise durch Fotolithografie, Siebdrucken oder Jetten aufgebracht werden.

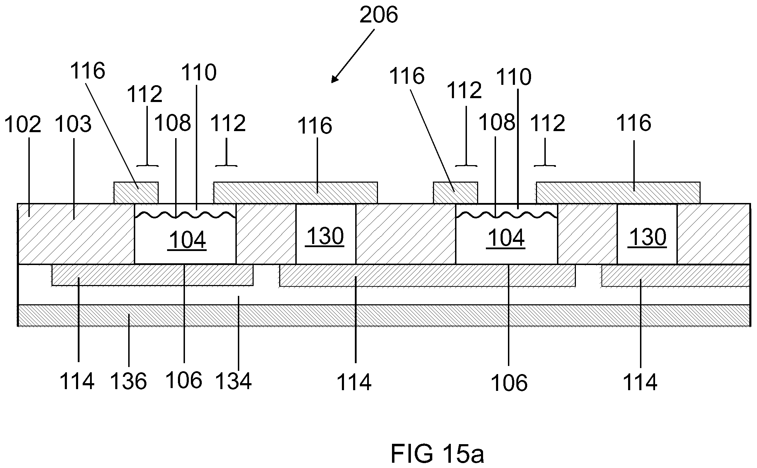

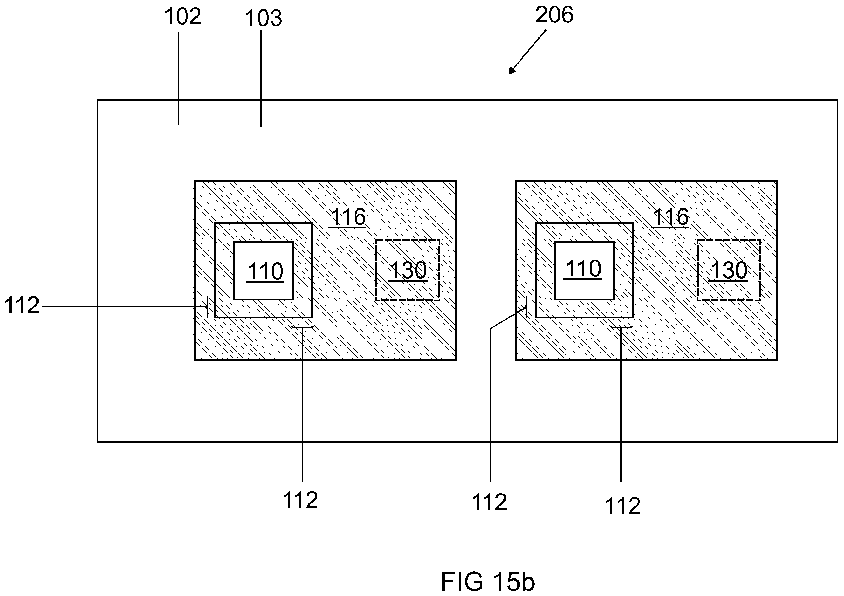

Das Endprodukt 206 nach Ausführung von Schritt S6 ist in den Figuren 15a und 15b gezeigt. Figur 15a zeigt ein drittes Ausführungsbeispiel eines erfindungsgemäßen optoelektronischen Moduls 206 in Schnittansicht. Figur 15b zeigt das erfindungsgemäße optoelektronische Modul 206 aus Figur 15a in Draufsicht. Das optoelektronische Modul 206 weist zwei Halbleiterchips 104 mit jeweils einer transparenten Kontaktschicht 110 auf. Die elektrischen Durchführungen 130 verbinden jeweils elektrisch leitend die erste Kontaktstruktur 114 eines ersten Halbleiterchips 104 mit der zweiten Kontaktstruktur 116 eines benachbarten Halbleiterchips 104. Die zweite Kontaktstruktur 116 ist in elektrischem Kontakt mit der transparenten Kontaktschicht 110 und bestromt diese von allen vier Seiten (siehe Figur 15b). Die zweite Kontaktschicht 116 ist flächig auf den Rahmen 103 aufgebracht und weist einen Überlappungsbereich 112 von beispielsweise 5 µm mit der transparenten Kontaktschicht 110 auf. Die beiden Halbleiterchips 104 sind seriell miteinander verschaltet. Hierfür sind die elektrischen Durchführungen 130 zwingend notwendig. Auf der Seite des Rahmens 103, die an die Kontaktfläche 106 angrenzt, ist eine elektrisch isolierende Isolationsschicht 134 aufgebracht. Auf der Isolationsschicht 134 ist eine, insbesondere metallische, Wärmesenke 136 aufgebracht.

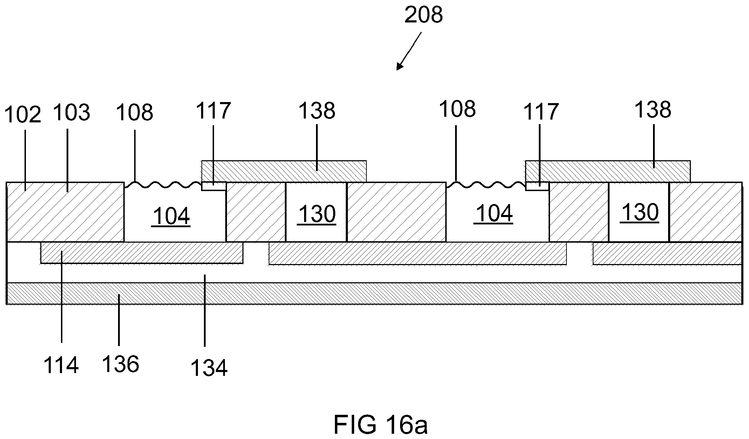

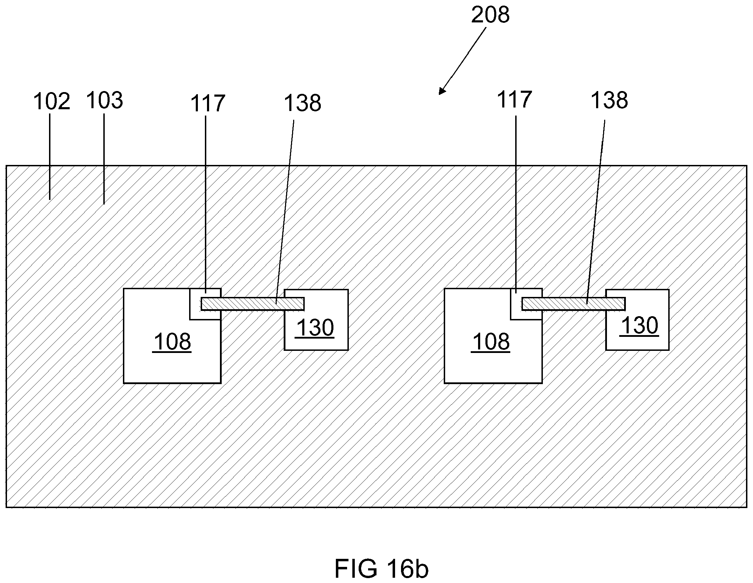

Das zum optoelektronischen Modul 206 alternative optoelektronische Modul 208 als Endprodukt von Schritt S6 ist in den Figuren 16a und 16b gezeigt. Figur 16a zeigt ein viertes Ausführungsbeispiel eines erfindungsgemäßen optoelektronischen Moduls 208 in Schnittansicht. Figur 16b zeigt das erfindungsgemäße optoelektronische Modul 208 aus Figur 16a in Draufsicht. Die erste Kontaktstruktur 114, die Anordnung der Isolationsschicht 134 und der Wärmesenke 136 des optoelektronischen Moduls 208 sind identisch zum optoelektronischen Modul 206. Die beiden Halbleiterchips 104 in Figur 16a und 16b sind seriell verschaltet. Die zweite Kontaktstruktur ist als planare Kontaktschicht 138 ausgebildet, die die elektrischen Durchführungen 130 elektrisch leitend mit den Kontaktpads 117 auf den Abstrahlflächen 108 der beiden Halbleiterchips 104 verbindet. Die Eigenschaften und Abmessungen der planaren Kontaktstruktur 138 und des Kontaktpads 117 sind beispielsweise in Figur 4a und 4b beschrieben.

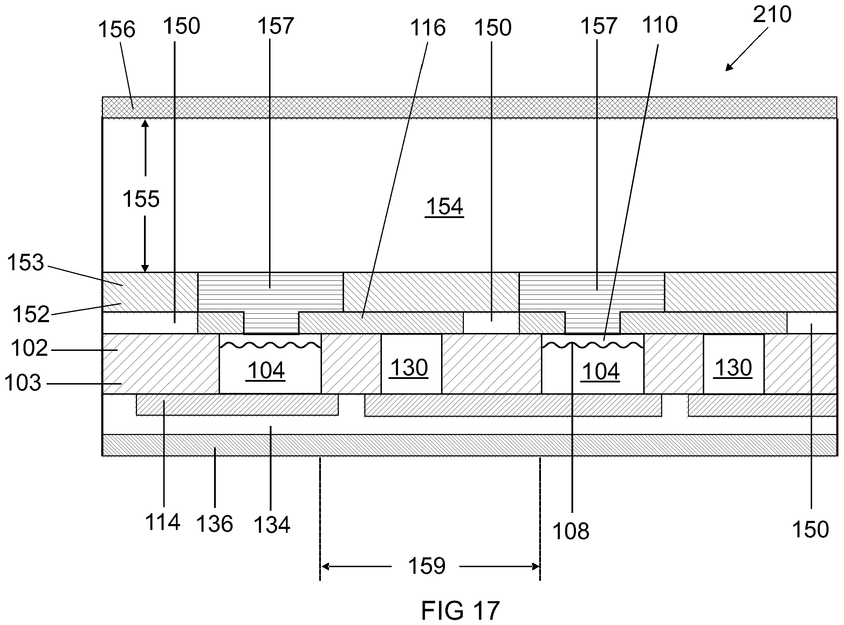

Im optionalen Schritt S7 wird ein Mischelement 154 auf die in Figur 15a dargestellte Anordnung aufgesetzt. Das Mischelement dient zur räumlichen und spektralen Durchmischung der elektromagnetischen Strahlung 118, die von den Halbleiterchips 104 abgestrahlt wird. Figur 17 zeigt ein fünftes Ausführungsbeispiel eines erfindungsgemäßen optoelektronischen Moduls 210 in Schnittansicht nach Ausführung des optionalen Schritts S7 des Herstellungsverfahrens. Die Wärmesenke 136, die elektrisch isolierende Schicht 134, die erste Kontaktstruktur 114, der Rahmen 103, die beiden Halbleiterchips 104 mit den zugehörigen Abstrahlflächen 108 und den auf den Abstrahlflächen 108 aufgebrachten transparenten Kontaktschichten 110 sowie die zweite Kontaktstruktur 116 sind identisch zum Ausführungsbeispiel in Figur 15a. Die Halbleiterchips 104 sind wie im Ausführungsbeispiel von Figur 15a seriell miteinander verschaltet. Im Gegensatz zum optoelektronischen Modul 206 in den Figuren 15a und 15b ist beim optoelektronischen Modul 210 ein Mischelement 154 vorgesehen. Das Mischelement 154 ist den Halbleiterchips 104 in Abstrahlrichtung nachgeordnet. Die Dicke 155 des Mischelements 154 entspricht im Wesentlichen dem Abstand 159 zwischen benachbarten Halbleiterchips 104. Die Dicke 155 kann beispielsweise Werte zwischen 1 mm und 10 mm, vorzugsweise zwischen 3 mm und 6 mm, besonders bevorzugt 4 mm aufweisen. Das Mischelement 154 kann beispielsweise Glas (SiO₂) oder Polymethylmethacrylat (PMMA) aufweisen.

Auf der vom Rahmen 103 abgewandten Fläche des Mischelements 154 kann beispielsweise eine Auskoppelschicht 156 angeordnet sein. Die Auskoppelschicht 156 kann als Aufrauung der Oberfläche des Mischelements 154 realisiert sein. Die Auskoppelschicht 156 ist vorteilhaft, da mehr Licht das Mischelement 154 verlassen kann. Die Aufrauung des Mischelements 154 kann bei der Herstellung des Mischelements 154 oder nachträglich erzeugt werden. Die Aufrauung kann beispielsweise eine Pyramidenstruktur aufweisen. Die Pyramiden können beispielsweise durch einen Sputterprozess in der Oberfläche des Mischelements 154 dargestellt werden. Die Größe der Auskoppelstrukturen liegen im Bereich einer oder mehrerer Wellenlängen des von den Halbleiterchips 104 emittierten Lichts, beispielsweise zwischen 50 nm und 5 µm, insbesondere zwischen 100 nm und 1 µm. Zwischen der Einheit aus Rahmen 103, Halbleiterchips 104 und elektrischen Durchführungen 130 und dem Mischelement 154 sind folgende Elemente angeordnet. Auf den Abstrahlflächen 108, genauer auf den transparenten Kontaktschichten 110, sind transparente Brechungsindex-Anpassungselemente 157, insbesondere aus Silikon, vorgesehen. Der Wert des Brechungsindex der transparenten Brechungsindex-Anpassungselemente 157 liegt zwischen dem Wert des Brechungsindex der Halbleiterchips 104 und dem Wert des Brechungsindex des Mischelements 154. Der Brechungsindex von Glas beträgt für Licht im sichtbaren Spektralbereich etwa 1,4. Der Brechungsindex von PMMA beträgt etwa 1,49. Der Brechungsindex für einen InGaN-Halbleiterchip beträgt etwa 2,4. Der Brechungsindex für einen InGaAlP-Halbleiterchip beträgt etwa 3,5. Vorzugsweise wird für die Brechungsindex-Anpassungselemente 157 hochbrechendes HRI-Silikon, mit einem Brechungsindex von etwa 1,6 verwendet.

Dem Rahmen 103 ist eine strukturierte Spiegelschicht 152 oder alternativ eine strukturierte Streuschicht 153 nachgeordnet. Die strukturierte Spiegelschicht 152 kann beispielsweise eine metallische Spiegelschicht, insbesondere aus Silber, sein. Die strukturierte Streuschicht 153 kann beispielsweise Silikon aufweisen, in das Streupartikel (nicht in Figur 17 gezeigt) dispergiert sind.

Die strukturierte Spiegelschicht 152 beziehungsweise Streuschicht 153 ist beispielsweise über ein Verbindungsmedium 150 mit dem Rahmen 103 verbunden. Das Verbindungsmedium 150 kann beispielsweise Silikon-Kleber sein. Das Verbindungsmedium 150 und das Brechungsindex-Anpassungselement 157 können beispielsweise aus dem gleichen Material bestehen und gleichzeitig im selben Prozess hergestellt werden.

Ein transparentes Brechungsindex-Anpassungselement 157 füllt den gesamten Hohlraum aus, der durch die plane Oberfläche der transparenten Kontaktschicht 110, die zweite Kontaktstruktur 116, die strukturierte Streuschicht 153 beziehungsweise die strukturierte Spiegelschicht 152 und das Mischelement 154 gebildet ist.

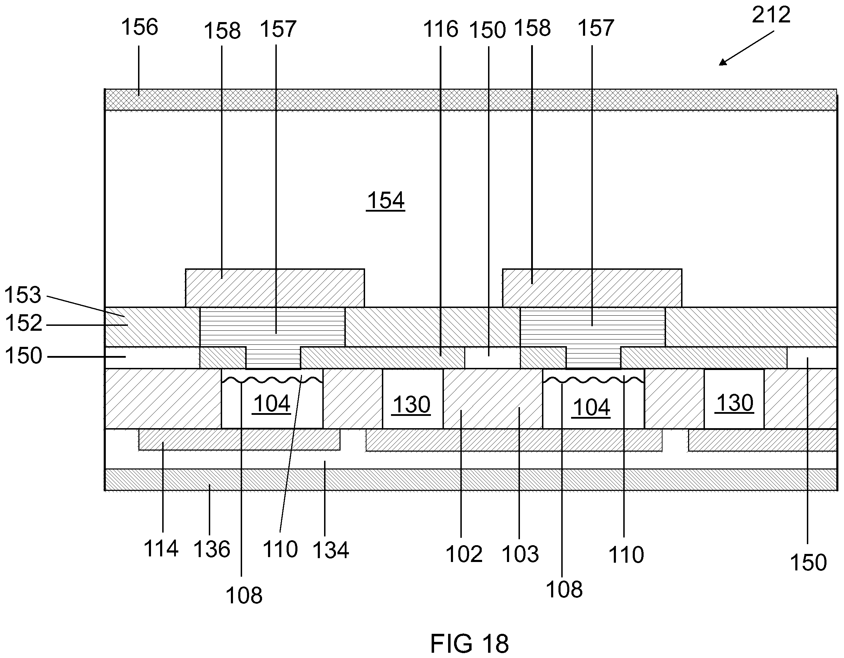

Figur 18 zeigt ein sechstes Ausführungsbeispiel eines erfindungsgemäßen optoelektronischen Moduls 212 in Schnittansicht nach Ausführung des optionalen Schritts S7 des Herstellungsverfahrens. Das optoelektronische Modul 212 unterscheidet sich nur dadurch vom optoelektronischen Modul 210 aus Figur 17, dass Konversionselemente 158 in das Mischelement 154 eingebracht sind. Die Konversionselemente 158 sind den transparenten Brechungsindex-Anpassungselementen 157 und den Halbleiterchips 104 in Abstrahlrichtung nachgeordnet. Die Konversionselemente 158 können beispielsweise Silikon aufweisen, in das Leuchtstoffpartikel, beispielsweise aus Yttriumaluminiumgranat (YAG), eingebettet sind. Die Kavitäten im Mischelement, die die Konversionselemente 158 aufnehmen, können durch Abformen eines Masters oder durch Heißprägen erzeugt werden.

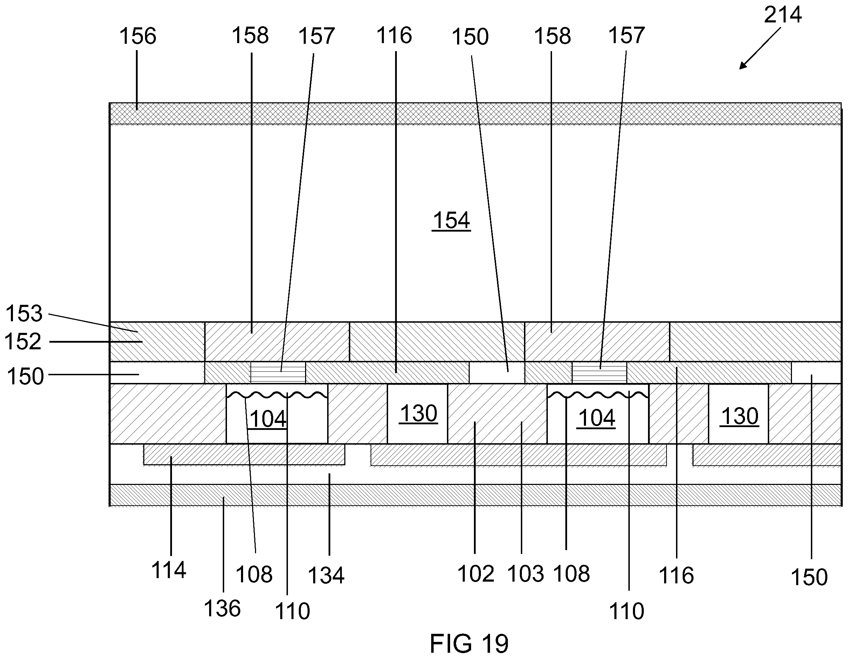

Figur 19 zeigt ein siebtes Ausführungsbeispiel eines erfindungsgemäßen optoelektronischen Moduls 214 in Schnittansicht nach Ausführung des optionalen Schritts S7 des Herstellungsverfahrens. Das optoelektronische Modul 214 entspricht im Wesentlichen dem optoelektronischen Modul 212. Nur die Konversionselemente 158 sind anders angeordnet. Die Konversionselemente 158 sind in den Ausnehmungen der strukturierten Spiegelschicht 152 beziehungsweise der strukturierten Streuschicht 153 angeordnet. Mit anderen Worten füllen die Konversionselemente 158 einen Großteil des im Text zu Figur 18 definierten Hohlraumes aus. Mit anderen Worten sind die Konversionselemente 158 zwischen dem Mischelement 154 und den Brechungsindex-Anpassungselementen 157 angeordnet.

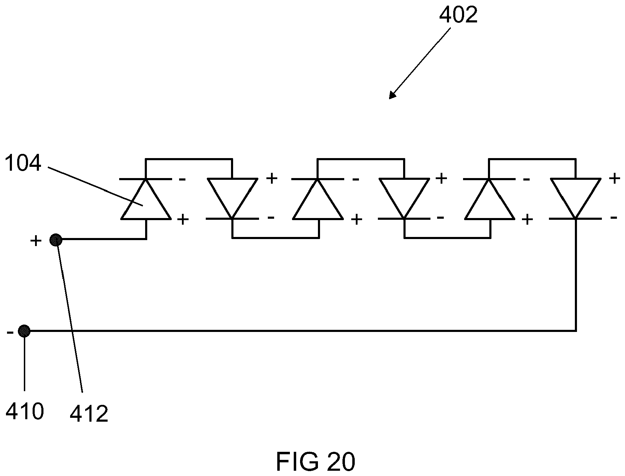

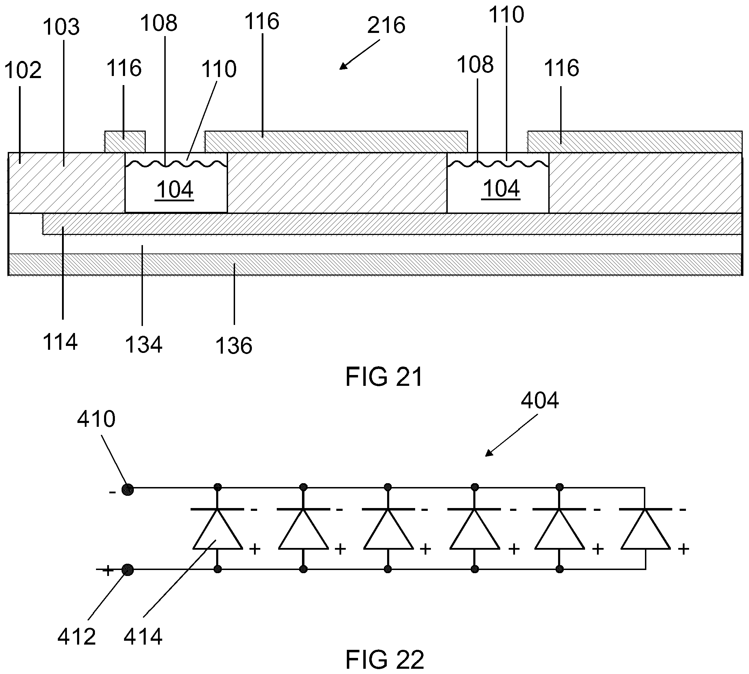

Figur 20 zeigt ein Ersatzschaltbild 402 für beispielsweise fünf seriell verschaltete Halbleiterchips 104. Bestromt werden die Halbleiterchips 104 durch einen ersten 410 und einen zweiten 412 externen Anschluss. Figur 21 zeigt ein achtes Ausführungsbeispiel eines erfindungsgemäßen optoelektronischen Moduls 216 in Schnittansicht nach Ausführung des Schritts S6 des Herstellungsverfahrens. Die beiden Halbleiterchips 104 sind über eine erste Kontaktstruktur 114 und eine zweite Kontaktstruktur 116 parallel miteinander verschaltet. Exemplarisch sind als Kontakte auf der Abstrahlfläche 108 transparente Kontaktschichten 110 dargestellt. In einem nicht gezeigten Ausführungsbeispiel können als Kontakte auf der Abstrahlfläche 108 mit der gleichen Funktion metallene Kontaktpads 117 eingesetzt werden. Es sind keine elektrischen Durchführungen 130 notwendig. Optional kann in einem Schritt S7 ein Mischelement 154 den Halbleiterchips 104 in Abstrahlrichtung nachgeordnet werden. Ein solches optoelektronisches Modul mit parallel verschalteten Halbleiterchips 104 ist nicht in den Figuren dargestellt, da bis auf die parallele Verschaltung der Halbleiterchips 104 das für optoelektronische Module (zum Beispiel Figuren 17, 18 und 19) mit seriell verschalteten Halbleiterchips 104 Gesagte gilt.

Figur 22 zeigt ein Ersatzschaltbild 404 für beispielsweise fünf parallel verschaltete Halbleiterchips 104. Bestromt werden die Halbleiterchips durch einen ersten 410 und einen zweiten 412 externen Anschluss.

In den optoelektronischen Modulen 210, 212, 214 und 216 sind die Halbleiterchips 104 jeweils über eine transparente Kontaktschicht 110 auf der Abstrahlfläche 108 kontaktiert. Alternativ können die Halbleiterchips 104 über ein Kontaktpad 117 auf der Abstrahlfläche 108 kontaktiert werden. Da optoelektronische Module, die Halbleiterchips 104 mit einem Kontaktpad 117 aufweisen, im Übrigen den optoelektronischen Modulen mit einer transparenten Kontaktschicht 110 entsprechen, wurde auf weitere Ausführungsbeispiele mit Halbleiterchips 104 mit einem Kontaktpad 117 verzichtet.

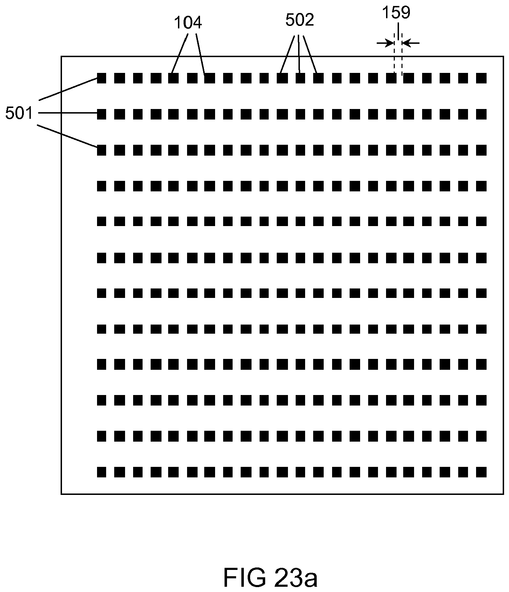

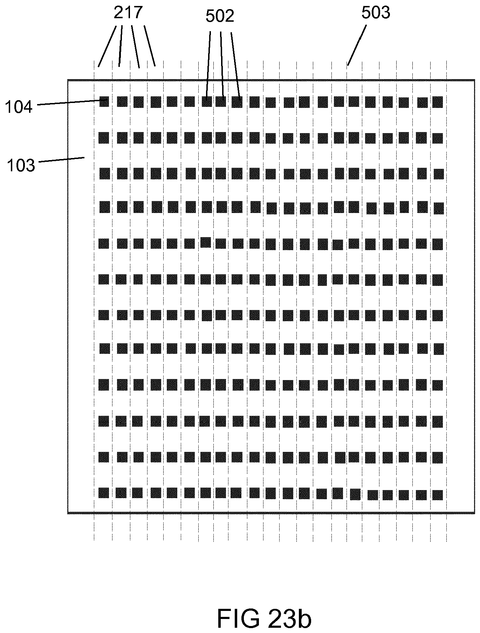

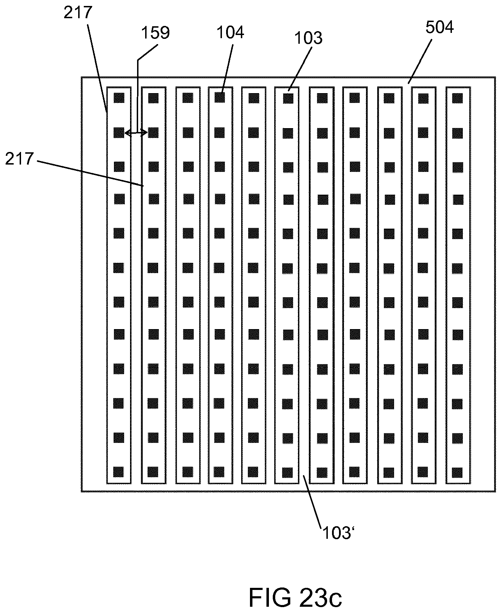

Die Figuren 23a, 23b, 23c zeigen anhand schematischer Aufsichten weitere Verfahrensschritte eines hier beschriebenen Verfahrens.

In der schematischen Aufsicht der Figur 23a ist ein hier beschriebenes optoelektronisches Modul schematisch dargestellt, bei dem eine Vielzahl von Halbleiterchips 104 in Reihen 501 und Spalte 502 auf der Klebefolie angeordnet und vom Rahmen 103 umgossen ist. Ferner sind die Halbleiterchips 104 zumindest bereits verdrahtet, das heißt das Aufbringen der ersten und/oder der zweiten Kontaktstrukturen 114, 116, 138 ist bereits erfolgt. Die Kontaktstrukturen sind dabei zur besseren Übersichtlichkeit in der Figur 23a nicht dargestellt.

In einem nachfolgenden Verfahrensschritt, Figur 23b, folgt ein Durchtrennen der Anordnung aus Halbleiterchips 104 und Rahmen 103 vorliegend zwischen den Spalten 502. Dadurch entstehen verkleinerte Module 217, die vorliegend lineare Module, siehe Figur 23c, sind.

Die verkleinerten Module 217 werden auf einem Hilfsträger 504, beispielsweise einer weiteren Klebefolie, angeordnet. Dabei wird der Abstand 159 zwischen direkt benachbarten Halbleiterchips 104 mit ihren Epitaxieschichtenfolgen, die unterschiedlichen direkt benachbarten verkleinerten Modulen 217 zugeordnet sind, im Vergleich zum Abstand 159 zwischen direkt benachbarten Halbleiterchips vor dem Durchtrennen vergrößert.

In einem nächsten Verfahrensschritt können die einzelnen verkleinerten Module 217 beispielsweise wieder zu einem größeren optoelektronischen Modul verbunden werden, indem Vergussmasse zur Bildung eines weiteren Rahmens 103' zwischen die verkleinerten Module 217 eingebracht wird.

Auf diese Weise entsteht ein optoelektronisches Modul, bei dem die Belegungsdichte mit optoelektronischen Halbleiterchips verringert ist.

Das optoelektronische Modul und das Verfahren zum Herstellen eines optoelektronischen Moduls wurden zur Veranschaulichung des zugrundeliegenden Gedankens anhand einiger Ausführungsbeispiele beschrieben. Die Ausführungsbeispiele sind dabei nicht auf bestimmte Merkmalskombinationen beschränkt. Auch wenn einige Merkmale und Ausgestaltungen nur im Zusammenhang mit einem besonderen Ausführungsbeispiel oder einzelnen Ausführungsbeispielen beschrieben wurden, können sie jeweils mit anderen Merkmalen aus anderen Ausführungsbeispielen kombiniert werden. Es ist ebenso möglich, in Ausführungsbeispielen einzelne dargestellte Merkmale oder besondere Ausgestaltungen wegzulassen oder hinzuzufügen, soweit die allgemeine technische Lehre realisiert bleibt.

Auch wenn die Schritte des Verfahrens zum Herstellen eines optoelektronischen Moduls in einer bestimmten Reihenfolge beschrieben sind, so ist es selbstverständlich, dass jedes der in dieser Offenbarung beschriebenen Verfahren in jeder anderen, sinnvollen Reihenfolge durchgeführt werden kann, wobei auch Verfahrensschritte ausgelassen oder hinzugefügt werden können, soweit nicht von dem Grundgedanken der beschriebenen technischen Lehre abgewichen wird.

Die folgenden Ansprüche definieren die Erfindung.

### Bezugszeichenliste

- 102: Vergussmasse
- 103: Rahmen aus Vergussmasse 102
- 103': weiterer Rahmen
- 104: Halbleiterchip
- 106: Kontaktfläche
- 108: Abstrahlfläche
- 110: transparente Kontaktschicht
- 112: Überlappungsbereich der zweiten Kontaktstruktur 116
- 114: erste Kontaktstruktur
- 116: zweite Kontaktstruktur
- 117: Kontaktpad auf Abstrahlfläche 108
- 118: elektromagnetische Strahlung
- 120: Schicht einer ersten Leitfähigkeit (zum Beispiel p-Leitfähigkeit)
- 121: elektrisch leitfähiges Substrat
- 122: aktive Zone
- 124: Schicht einer zweiten Leitfähigkeit (zum Beispiel n-Leitfähigkeit)
- 130: elektrische Durchführung
- 132: Klebefolie
- 134: elektrisch isolierende Schicht
- 136: Wärmesenke
- 138: planare Kontaktschicht (CPHF) als zweite Kontaktstruktur 116
- 140: Basis der Moldform
- 142: Deckel der Moldform
- 144: Träger der Moldform
- 146: Deckfolie
- 150: Verbindungsmedium
- 152: strukturierte Spiegelschicht
- 153: strukturierte Streuschicht
- 154: Mischelement
- 155: Dicke des Mischelements 154
- 156: Auskoppelschicht
- 157: Brechungsindex-Anpassungselement
- 158: Konversionselement
- 159: Abstand zwischen benachbarten Halbleiterchips 104
- 202 bis 216: optoelektronisches Modul
- 217: verkleinertes Modul
- 302 bis 318: Zwischenprodukte des Herstellungsverfahrens
- 402 und 404: Ersatzschaltbild
- 410: erster, externer elektrischer Anschluss
- 412: zweiter, externer elektrischer Anschluss
- 501: Reihe
- 502: Spalte
- 503: Trennlinie
- 504: Hilfsträger

## Patentansprüche

1. Verfahren zum Herstellen eines optoelektronischen Moduls (202, 204, 206, 208, 210, 212, 214, 216) mit den folgenden Schritten:
- Aufbringen mindestens eines Halbleiterchips (104) zur Emission elektromagnetischer Strahlung (118) auf eine Klebefolie (132), wobei der Halbleiterchip (104) eine Schicht einer ersten Leitfähigkeit (120), eine Schicht einer zweiten Leitfähigkeit (124), eine Abstrahlfläche (108) mit einem Kontakt (110, 117) und eine der Abstrahlfläche (108) gegenüberliegende Kontaktfläche (106) aufweist und wobei die Abstrahlfläche (108) zur Klebefolie (132) weist;
- Aufbringen eines Rahmens (103) aus Vergussmasse (102) auf die freiliegenden Bereiche der Klebefolie (132), derart, dass der Halbleiterchip (104) seitlich zumindest bereichsweise von Vergussmasse (102) umschlossen wird;
- Aufbringen einer ersten Kontaktstruktur (114) auf den Rahmen (103) und auf die Kontaktfläche (106) zur elektrischen Kontaktierung der Schicht einer ersten Leitfähigkeit (120);
- Entfernen der Klebefolie (132);
- Aufbringen einer zweiten Kontaktstruktur (116, 138) auf den Rahmen (103) und auf den Kontakt (110, 117) der Abstrahlfläche (108), zur elektrischen Kontaktierung der Schicht einer zweiten Leitfähigkeit (124),
wobei dem Schritt des Aufbringens des Rahmens (103) aus Vergussmasse (102) ein Schritt des Aufbringens mindestens einer elektrischen Durchführung (130) auf die Klebefolie (132) vorangeht.

2. Verfahren gemäß Anspruch 1,
wobei der Schritt des Aufbringens des Rahmens (103) aus Vergussmasse (102) folgende Teilschritte aufweist:
- Formpressen der Vergussmasse (102), die den Halbleiterchip (104) und/oder die elektrische Durchführung (130) zumindest bereichsweise umschließt;
- Aushärten der Vergussmasse (102);
- Rückschleifen der ausgehärteten Vergussmasse (102), derart, dass die Kontaktfläche (106) und/oder die der Klebefolie (132) gegenüberliegende Fläche der elektrischen Durchführung (130) von Vergussmasse (102) befreit wird.

3. Verfahren gemäß Anspruch 1 oder 2,
wobei der Schritt des Aufbringens des Rahmens (103) aus Vergussmasse (102) folgende Teilschritte aufweist:
- Aufbringen einer Deckfolie (146), insbesondere aus Teflon, auf die Kontaktfläche (106) und/oder auf die der Klebefolie (132) gegenüberliegende Fläche der elektrischen Durchführung (130);
- Spritzgießen der Vergussmasse (102) in einen Zwischenraum zwischen Deckfolie (146) und Klebefolie (132), derart dass der Halbleiterchip (104) und/oder die elektrische Durchführung (130) an den Seiten, die nicht von der Klebefolie (132) und nicht von der Deckfolie (146) bedeckt sind, von Vergussmasse (102) umschlossen werden;
- Aushärten der Vergussmasse (102);
- Entfernen der Deckfolie (146).

4. Verfahren gemäß einem der Ansprüche 1 bis 3,
wobei dem Schritt des Aufbringens der ersten Kontaktstruktur (114) folgende Teilschritte nachfolgen:
- Aufbringen einer elektrisch isolierenden, insbesondere dielektrischen, Schicht (134);
- Aufbringen einer, insbesondere metallischen, Wärmesenke (136) auf die elektrisch isolierende Schicht (134).

5. Verfahren gemäß einem der Ansprüche 1 bis 4,
wobei dem Schritt des Aufbringens der zweiten Kontaktstruktur (116, 138) der Schritt des Aufbringens eines Mischelements (154) zur räumlichen Durchmischung elektromagnetischer Strahlung nachfolgt.

6. Verfahren gemäß einem der Ansprüche 1 bis 5,
wobei
- eine Vielzahl von Halbleiterchips (104) auf die Klebefolie (132) aufgebracht wird,
- die Vielzahl von Halbleiterchips (104) in Reihen (501) und Spalten (502) auf der Klebefolie (132) angeordnet wird,
- nach dem Aufbringen der ersten und/oder zweiten Kontaktstrukturen (114, 116, 138) die Anordnung aus Halbleiterchips (104) und Rahmen (103) zwischen den Reihen (501) oder/oder den Spalten (502) zur Erzeugung von verkleinerten Modulen (217) durchtrennt wird,
- die verkleinerten Module (217) auf einem Hilfsträger nebeneinander zur Bildung des optoelektronischen Moduls angeordnet werden, wobei der Abstand (159) zwischen direkt benachbarter Halbleiterchips (104) aus unterschiedlichen direkt benachbarten verkleinerten Modulen (217) größer ist, als der Abstand (159) zwischen direkt benachbarten Halbleiterchips (104) vor dem Durchtrennen.

## Claims

1. Method for producing an optoelectronic module (202, 204, 206, 208, 210, 212, 214, 216) with the following steps:
- applying at least one semiconductor chip (104) for emitting electromagnetic radiation (118) to an adhesive film (132), wherein the semiconductor chip (104) has a layer of a first conductivity (120), a layer of a second conductivity (124), a radiating surface (108) with a contact (110, 117) and a contact surface (106) opposite the radiating surface (108), and wherein the radiating surface (108) faces the adhesive film (132);
- applying a frame (103) of potting compound (102) to the exposed regions of the adhesive film (132) in such a way that the semiconductor chip (104) is laterally surrounded at least in regions by potting compound (102);
- applying a first contact structure (114) to the frame (103) and to the contact surface (106) for electrically contacting the layer of a first conductivity (120);
- removing the adhesive film (132);
- applying a second contact structure (116, 138) to the frame (103) and to the contact (110, 117) of the radiating surface (108) for electrically contacting the layer of a second conductivity (124),
wherein the step of applying the frame (103) of potting compound (102) is preceded by a step of applying at least one electrical feedthrough (130) to the adhesive sheet (132).

2. Method according to claim 1,
wherein the step of applying the frame (103) of potting compound (102) comprises the following partial steps:
- compression moulding of the potting compound (102), which encloses the semiconductor chip (104) and/or the electrical feedthrough (130) at least in regions;
- curing of the potting compound (102);
- grinding back the cured potting compound (102) in such a way that the contact surface (106) and/or the surface of the electrical feedthrough (130) opposite the adhesive film (132) is freed from potting compound (102).

3. Method according to claim 1 or 2,
wherein the step of applying the frame (103) of potting compound (102) comprises the following partial steps:
- applying a cover film (146), in particular made of Teflon, to the contact surface (106) and/or to the surface of the electrical feedthrough (130) opposite the adhesive film (132) ;
- injection moulding of the potting compound (102) into an interspace between the cover film (146) and the adhesive film (132) in such a way that the semiconductor chip (104) and/or the electrical feedthrough (130) are enclosed by potting compound (102) on the sides which are not covered by the adhesive film (132) and not covered by the cover film (146);
- curing the potting compound (102);
- removing the cover film (146).

4. Method according to one of claims 1 to 3,
wherein the step of applying the first contact structure (114) is followed by the following partial steps:
- applying an electrically insulating, in particular dielectric, layer (134);
- applying a, in particular metallic, heat sink (136) to the electrically insulating layer (134).

5. Method according to one of claims 1 to 4,
wherein the step of applying the second contact structure (116, 138) is followed by the step of applying a mixing element (154) for spatial mixing of electromagnetic radiation.

6. Method according to one of claims 1 to 5,
wherein
- a plurality of semiconductor chips (104) is applied to the adhesive film (132),
- the plurality of semiconductor chips (104) are arranged in rows (501) and columns (502) on the adhesive sheet (132),
- after the application of the first and/or second contact structures (114, 116, 138), the arrangement of semiconductor chips (104) and frame (103) is severed between the rows (501) and/or the columns (502) to produce reduced-size modules (217),
- the reduced-size modules (217) are arranged next to one another on an auxiliary carrier to form the optoelectronic module, wherein the distance (159) between directly adjacent semiconductor chips (104) from differently directly adjacent reduced-size modules (217) is greater than the distance (159) between directly adjacent semiconductor chips (104) prior to the severing.

## Revendications

1. Méthode de fabrication d'un module optoélectronique (202, 204, 206, 208, 210, 212, 214, 216) avec les étapes suivantes:
- appliquer au moins une puce semi-conductrice (104) pour l'émission d'un rayonnement électromagnétique (118) sur un film adhésif (132), la puce semi-conductrice (104) présentant une couche d'une première conductivité (120), une couche d'une deuxième conductivité (124), une surface rayonnante (108) avec un contact (110, 117) et une surface de contact (106) opposée à la surface rayonnante (108), et la surface rayonnante (108) étant tournée vers le film adhésif (132);
- appliquer un cadre (103) d'une masse de remplissage (102) sur les régions exposées du film adhésif (132) de telle sorte que la puce semi-conductrice (104) soit entourée latéralement au moins par endroits de la masse de remplissage (102);
- appliquer une première structure de contact (114) sur le cadre (103) et sur la surface de contact (106) pour établir un contact électrique avec la couche d'une première conductivité (120);
- enlever le film adhésif (132);
- appliquer une deuxième structure de contact (116, 138) sur le cadre (103) et sur le contact (110, 117) de la surface rayonnante (108) pour établir un contact électrique avec la couche d'une deuxième conductivité (124),
dans laquelle l'étape d'application du cadre (103) de la masse de remplissage (102) est précédée d'une étape d'application d'au moins une traversée électrique (130) sur le film adhésif (132).

2. Méthode selon la revendication 1,
dans laquelle l'étape d'application du cadre (103) de la masse de remplissage (102) comprend les étapes partielles suivantes:
- moulage par compression de la masse de remplissage (102), qui entoure la puce semi-conductrice (104) et/ou la traversée électrique (130) au moins par endroits;
- durcir la masse de remplissage (102);
- meuler la masse de remplissage (102) durcie de telle sorte que la surface de contact (106) et/ou la surface de la traversée électrique (130) opposée au film adhésif (132) soit libérée de la masse de remplissage (102).

3. Méthode selon la revendication 1 ou 2,
dans laquelle l'étape d'application du cadre (103) de la masse de remplissage (102) comprend les étapes partielles suivantes:
- appliquer un film de recouvrement (146), en particulier en téflon, sur la surface de contact (106) et/ou sur la surface de la traversée électrique (130) opposée au film adhésif (132) ;
- moulage par injection de la masse de remplissage (102) dans un espace intermédiaire entre le film de recouvrement (146) et le film adhésif (132) de telle sorte que la puce semi-conductrice (104) et/ou la traversée électrique (130) soient entourées par la masse de remplissage (102) sur les côtés qui ne sont pas recouverts par le film adhésif (132) et qui ne sont pas recouverts par le film de recouvrement (146);
- durcir la masse de remplissage (102);
- enlever le film de recouvrement (146).

4. Méthode selon l'une des revendications 1 à 3,
dans laquelle l'étape d'application de la première structure de contact (114) est suivie des étapes partielles suivantes:
- appliquer une couche électriquement isolante (134), en particulier diélectrique;
- appliquer un dissipateur thermique, en particulier métallique (136), sur la couche électriquement isolante (134) .

5. Méthode selon l'une des revendications 1 à 4,
dans laquelle l'étape d'application de la deuxième structure de contact (116, 138) est suivie de l'étape d'application d'un élément de mélange (154) pour le mélange spatial du rayonnement électromagnétique.

6. Méthode selon l'une des revendications 1 à 5,
dans laquelle
- une pluralité de puces semi-conductrices (104) est appliquée sur le film adhésif (132),
- la pluralité de puces semi-conductrices (104) est disposée en lignes (501) et en colonnes (502) sur le film adhésif (132),
- après l'application de la première et/ou de la deuxième structure de contact (114, 116, 138), l'agencement des puces semi-conductrices (104) et du cadre (103) est découpé entre les lignes (501) et/ou les colonnes (502) pour produire des modules de taille réduite (217),
- les modules de taille réduite (217) sont disposés les uns à côté des autres sur une support auxiliaire pour former le module optoélectronique, la distance (159) entre des puces semi-conductrices (104) directement adjacents de différents modules de taille réduite (217) étant supérieure à la distance (159) entre des puces semi-conductrices (104) directement adjacentes avant le découpage.
